Europäisches Patentamt

(19) European Patent Office (11) Publication number: **0 020 640**

Office européen des brevets **B1**

(12) **EUROPEAN PATENT SPECIFICATION**

(45) Date of publication of patent specification: **24.10.84** (51) Int. Cl.³: **H 03 F 3/21, H 03 F 3/30, H 03 F 3/68, H 02 M 5/44, G 05 F 1/44**

(21) Application number: **79901641.5**

(22) Date of filing: **06.11.79**

(86) International application number:
**PCT/US79/00952**

(87) International publication number:
**WO 80/01023 15.05.80 Gazette 80/11**

(54) **HIGH EFFICIENCY, LIGHT WEIGHT AUDIO AMPLIFIER AND POWER SUPPLY.**

(30) Priority: **06.11.78 US 958141**
**05.04.79 US 27471**

(43) Date of publication of application:
**07.01.81 Bulletin 81/01**

(45) Publication of the grant of the patent:
**24.10.84 Bulletin 84/43**

(84) Designated Contracting States:
**FR**

(56) References cited:
**DE-A-2 423 098**
**DE-B-1 167 917**
**FR-A-2 376 556**
**US-A-3 426 290**
**US-A-3 483 425**
**US-A-3 486 128**
**US-A-3 725 676**
**US-A-4 021 684**
**US-A-4 054 843**
**US-A-4 087 850**

(73) Proprietor: **CARVER, Robert Weir**
**330 Avenue A**
**Snohomish, WA 98290 (US)**

(72) Inventor: **CARVER, Robert Weir**
**330 Avenue A**
**Snohomish, WA 98290 (US)**

(74) Representative: **Flechner, Willy**
**CABINET FLECHNER 22, Avenue de Friedland**
**F-75008 Paris (FR)**

(56) References cited:
**ELECTRICAL COMMUNICATION, vol. 51, no. 1, 1976, pages 28-33 New York, U.S.A. F.E. MÜLLER: "Interference elimination in switching regulated power supplies"**

Courier Press, Leamington Spa, England.

## Description

### Technical field

This invention relates to methods for audio signal amplification and to audio amplifier circuitry and power supplies therefor.

### Background art

Solid state circuit components have brought incredible reduction in the size, weight and cost of audio amplifier circuitry and have also achieved increased fidelity in sound reproduction as compared with vacuum tube technology of a prior-generation. In an attempt to exploit to the limit the potential of solid state circuitry, audio engineers have striven to provide the user with increased power ratings while simultaneously achieving decreased distortion levels. Their efforts have met with resounding success, but have produced some undesirable side effects primarily in the areas of increased weight, cost and power consumption. For example, a commercially available state-of-the art 400 watt amplifier typically weighs anywhere from 16 kg to over 38 kg depending upon the particular design and choice of materials. Such amplifiers normally employ costly components necessitated by the peak loads which they must carry, and generate significant amounts of heat which must be dissipated to avoid component damage.

With regard to the transformer weight problem an obvious approach would be to reduce the number of windings and/or the gauge of the wire making up the transformer coils. However, reduction in the number of windings also reduces the inductance in the primary coil, thereby increasing idling currents' through the coil and contributing to both heat generation and increased power consumption. The conventional method for achieving low idling currents in the primary has been to use a large number of windings. This approach also requires a large number of windings in the secondary to keep the voltage in the secondary at the proper level. The other obvious alternative for weight reduction, i.e. reduction in the wire gauge, is not an acceptable solution since the internal resistance of each coil would be increased, leading to excessive heat generation and power loss upon high power demands being placed on the transformer. Conventional wisdom has thus taught the necessity of increasing the size and weight of the transformer whenever a transformer powered amplifier is redesigned for increased power rating.

An alternative approach for reducing the overall weight, size and cost of audio amplifiers has been to reduce the total input power requirement without decreasing output power capability. Such increases in amplifier efficiency permit the use of less costly, lower weight power supplies, and can be achieved by reducing the power dissipation which normally attends the conventional use of output transistors in the output stage of the amplifier. When such power dissipation decreases are achieved, additional weight and cost savings are realized beyond those realized in the power supply since the weight, size and cost of the heat sinks normally required by the output transistors in the amplifier may also be reduced.

U.S. Patent No. 3,426,290 to Jensen is representative of one known approach for increasing amplifier efficiency by keeping the voltage supplied to the output transistor of the amplifier very close to the output voltage level, thereby permitting operation of the output transistor in a condition which is at all times only slightly out of saturation. When operated in this condition, the actual voltage drop across the output transistor will be maintained quite low and the power dissipated by the transistor (equal to voltage across the transistor X current through the transistor) will be correspondingly reduced. A rather complex regulator is employed in the Jensen circuit to maintain the desired voltage supply to the output transistor wherein energy is stored in an inductive capacitive circuit by means of a switching transistor operated at high speed in response to a control signal derived from the audio input signal. By operating the switching transistor in full "on" or full "off" condition to maintain the desired voltage supply to the amplifier output transistor, energy consumption by the combined regulator and output transistor is reduced over that which would be consumed by an output transistor operated with a conventional fixed supply voltage. While producing a decided advantage in amplifier efficiency, the Jensen circuit is only truly effective if the switching transistor is operated at high frequencies, which can in turn cause transient interference distortion in the amplifier output signal. U.S. Patent No. 4,054,843 to Hanada discloses a similar circuit to that disclosed in Jensen.

An alternative approach to achieving improved amplifier efficiency is disclosed in the patent to Dryden (3,319,175) which discloses a stepped voltage supply operated in response to the voltage level of the amplifier output whereby the minimum voltage from the available power supply voltages sufficient to achieve the desired amplification is applied across the power amplifying element. While useful for the purposes disclosed, Dryden employs only a single transistor as the power amplifying element for each polarity of the output voltage and thus the entire difference between the load voltage and the connected supply voltage appears across the output transistor. Significant power losses will thus occur unless a large number of discrete supply voltages are provided by the power supply circuitry. Each such discrete voltage requires a separate amplitude comparator and associated switching device thus adding significantly to the cost of the power supply.

Still another approach disclosed in the prior art is illustrated in U.S. Patent No. 3,622,899 to Elsenberg. In this patent a low power dissipation amplifier circuit is disclosed including plural transistors coupled in series to a load terminal wherein the transistors are energized by respective voltage sources having different magnitudes and wherein the transistors are biased to operate as amplifiers in sequence in response to an input signal of increasing magnitude. This type of circuit causes each output transistor to be driven into saturation as the next higher voltage output transistor is brought into operation, causing substantially the entire voltage drop in the amplifier output stage (that is the difference between the supply voltage and the load or output voltage) to appear across only a single output transistor at any one time. This arrangement of circuitry requires output transistors having substantial power ratings unless a relatively large number of output transistors and discrete supply voltages are provided. Either approach will add to amplifier cost. The patents to Woehner (US—A—3,772,606) and to Sampei et al. (US—A—3,961,280) disclose circuit arrangements similar to that described above with reference to the Elsenberg patent.

The patent to Schade, Jr. (US—A—3,887,878) discloses a transistor series amplifier wherein plural series connected transistors in the output stage are biased to share the total voltage drop in the output stage to permit use of lower cost components. However, this patent fails to disclose a technique for reducing the total power dissipation in such transistors.

Still other techniques for reducing the cost of amplifier power supplies have been disclosed in the prior art. For example in the U.S. patent to Munch, Jr. (3,542,953) a technique is disclosed wherein a single power supply may serve two Class B amplifier circuits designed to amplify the same audio signal by phase inverting the input to one amplifier to cause the amplifiers to draw peak current from the power supply in alternation. Munch, Jr. does not, however, suggest how such a technique can be employed in a system employing dual amplifiers (such as in a sterophonic system) for amplifying two separate signals.

None of the prior art systems discussed above addresses directly the problem of reducing power supply weight and costs by modifying the supply itself in a manner to employ less costly lighter, weight components while maintaining the power supply capabilities required by the amplifier circuit.

The patent to Chun (US—A—3,466,527) discloses a circuit for reducing the cost and size of a transformer based voltage supply circuit including a duty cycle controlled switch in the A.C. power supply circuit of the transformer primary. The switch functions to regulate output voltage from the secondary. However, the lower cost and weight capability achieved by the concepts disclosed in Chun are derived by operating the duty cycle controlled switch over only a quarter cycle volt-time integral and do not in any way suggest how such a circuit design could be employed in an audio amplifier circuit in a manner to obtain power supply weight and cost reductions based on the characteristics of the incoming audio signals.

Disclosure of the invention

It is a general object of this invention to overcome the difficiencies of the prior art by providing an amplifier circuit and power supply of significantly reduced weight and cost achieved by simultaneously increasing the efficiency of the amplifier output stage and modulating the energization of the amplifier power supply in response to a characteristic of the signal being amplified.

Another object of this invention is to provide a transformer based power supply for an audio amplifier in which the transformer primary is energized by a pulsed supply which is duty cycle modulated partially in response to the signal being amplified. The duty cycle is controlled in a manner to insure that adequate power is available in the power supply output energized by the transformer secondary while at the same time minimizing the time during each cycle when idling currents are flowing through the primary winding of the transformer.

The apparatus according to the invention is of the type disclosed in US—A—3466527 and defined in the preamble of the main claim, and is characterized by the characterizing part of the main claim.

The above objects are achieved in one specific embodiment by providing a transformer based power supply for an audio amplifier for amplifying an audio signal having an amplitude which varies at an audio frequency, wherein the primary of the transformer may be connected with a source of sinusoidally varying voltage having a constant frequency within the audio range combined with a switch means arranged to cyclically interrupt the alternating current in response to a control signal produced by control means operatively connected to the switch means to cause the switch means to be conductive at selected portions of voltage cycles from the power input terminal means. The control means causes the switch means to be conductive for shorter periods of time for lower power requirements of the amplifying apparatus, and to be conductive for longer periods of time for higher power requirements of the amplifying apparatus. Desirably, the control means causes the switch means to be conductive during a latter portion of each voltage pulse from said power input terminal. In one embodiment, there is a rectifying means operatively connected with the power input terminal means and the primary winding to cause only terminal means and the primary winding to cause only positive current pulses to be directed to the primary winding. The switch means comprises voltage responsive switch means which becomes conductive at predetermined voltage levels of the voltage pulses. In the preferred form of this embodiment, the switch means comprises a silicon controlled rectifier connected in series between the power input terminal means and the primary winding of the transformer.

In another embodiment of the transformer based power supply, the power input terminal means is connected to the primary winding to cause alternating voltage to be delivered to the primary winding. The switch means is a voltage responsive means to cause the switch means to be conductive at predetermined voltage levels during latter portions of the voltage pulses. In the preferred form of this additional embodiment of the power supply, the switch means comprises a first triac connected in series with the primary winding. Operation of the first triac is governed by circuitry which responds to both the magnitude of the signal being amplified and the value of the voltage output from the transformer secondary. The triac is caused to fire during precisely defined portions of the duty cycle, thereby regulating the amount of current flow through the transformer primary and the corresponding transfer of energy to the transformer secondary.

In another form of the transformer based power supply, the triac switching means discussed above further includes cut off circuitry for shutting off current flow through the primary of the transformer before the normal waveform of the alternating voltage supply has returned to zero. Such cut off circuitry may include a second triac which operates to commutate the first triac into a non-conductive state.

Still another object of this invention is to provide a high efficiency audio amplifier including the power supply described above and further.

In one embodiment of the audio amplifier, a plurality of series connected output transistors are connected in emitter follower configuration to the output of the amplifier. The transistor closest to the output is connected through its base to signal input means. The remaining transistors are controlled through their base electrodes by transistor control means designed to cause the series connected transistors to be non-conductive under conditions where said amplifying apparatus is amplifying a signal having an amplitude below a predetermined magnitude. The transistor control means causes the second transistor to become conductive under circumstances where the input signal is of a higher magnitude so that current at a higher voltage is delivered to the output terminal, with the result that current flows from the higher voltage point to the second and first transistors to the output terminal. In the preferred form, the transistor control means is responsive to output voltage from the first transistor to the load terminal. Further, the transistor control means is operatively connected to a base electrode of the second transistor in a manner that control current to the base electrode of the second transistor begins to flow when the output voltage reaches a predetermined voltage level, so as to cause the second transistor to be conductive and cause current to flow from the higher voltage point through said first and second transistors to the output terminal.

Desirably, the transistor control means is further characterized in that the first control means supplies base current to the base electrode of the second transistor according to a functional relationship of the output voltage at the output terminal. This is done in a manner that voltage of the current supplied to the base electrode of the second transistor varies as a function of magnitude of the output voltage, with the voltage of the base current to the second transistor being a voltage level intermediate the voltage at the higher voltage point and the output voltage, with the result that voltage drop across the second and first transistors is shared between the second and first transistors.

Specifically, the transistor control means comprises a control transistor having a first main current carrying electrode connected to the base electrode of the second transistor, and a second main current carrying electrode connected to voltage dividing means connected between said output terminal and a related higher voltage source. The base electrode of the control transistor is connected to a junction point between a pair of voltage dividing resistors, which in turn are connected between higher and lower voltage sources.

There is diode means inter-connecting the lower voltage point with the second electrode of the first transistor, so that when the signal voltage is at a level higher than a voltage level of the lower voltage point, the lower voltage point is blocked off from the higher voltage point.

In the preferred configuration, there are two sets of transistors arranged in push pull relationship, with at least two transistors being in each set. One set of transistors conducts during positive portions of the signal voltage, and the other set conducts during negative cycle portions of the signal voltage. The first set is connected to greater and lesser positive voltage points on the secondary winding of the transformer, while the other set of transistors is connected to greater and lesser negative voltage points on the secondary winding of the transistor. The first and second control means functions in substantially the same manner as indicated previously herein.

In still another embodiment of the subject invention, the audio amplifier includes a primary output transistor the base of which is responsive to the audio signal and the emitter collector circuit of which is connected between a first supply voltage and the amplifier output. Second and third transistors have their emitters connected through diodes to the collector of the first transistor and have their collectors connected, respectively, to second and third supply voltages which are higher than the first supply voltage. In this embodiment control circuit means are provided responsive to the amplifier output to cause the second and third transistors to sequentially commence conducting in response to the output voltage from the amplifier exceeding the first and second supply voltages, respectively. By this arrangement the voltage drop within the output stage of the amplifier occurs in one of the three ways as follows:

(a) solely across the first transistor,
(b) solely across the first and second transistors, or
(c) solely across the first and third transistors.

An additional feature of this invention is to provide a transformer based power supply circuit for an audio amplifier in which the transformer primary coil is energized by an A.C. current duty cycle modulated by a solid state switch which is, in turn, controlled by a phase shift network wherein the amount of phase shift is a function of the power supply output voltage and of the audio signal being amplified. The phase shift network may be connected by means of a light photon coupled communication link to control circuitry responsive to the output voltage of the power supply and a signal which tracks the audio signal being amplified. By this arrangement, the duty cycle of the A.C. signal applied to the transformer primary may be modulated to cause the amount of current flowing through the primary to be adjusted to be just sufficient to satisfy the power needs of the amplifier, thereby substantially reducing primary coil idling currents. In a preferred embodiment, the power supply circuit may be equipped with an automatic shut down capability in response to any one of the following conditions: over current or over voltage in the amplifier output or a direct current fault in the amplifier circuitry.

In yet another embodiment of this invention, the duty cycle controlled power supply circuit is desirably equipped with a transformer having a secondary to primary turns ratio below 1.0 with a primary induction above 30 millihenries and a coil wire gauge diameter above No. 18 when the transformer is used to produce approximately 1000, watts at a maximum $\pm 75$ volt D.C. output from conventional 117—125 volt, 60 cycle alternating current.

Still other and more specific objects of this invention will become apparent from a consideration of the following Brief Description of the Drawings and Best Mode for Carrying Out the Invention.

Brief description of the drawings

Figure 1 is a schematic diagram illustrating the basic concepts of the present invention;

Figure 2 is a block diagram of one embodiment of a power supply and amplifier designed in accordance with the present invention;

Figure 3 is a circuit diagram of the power supply and amplifier illustrated in Figure 2;

Figure 4 is a modification of the switching circuitry for controlling the operation of the power supply illustrated in Figure 3;

Figure 5 is a circuit diagram of a stepped voltage power supply;

Figure 6A, 6B and 6C illustrate various current cycle waveforms flowing through the primary winding of the power supply of Figure 5;

Figure 7A is an alternative embodiment of a stepped voltage power supply;

Figure 7B is a first modification of the switching circuitry for controlling the operation of the stepped voltage power supply of Figure 7A;

Figure 7C is a second modification of the switching circuitry for controlling the operation of the stepped voltage power supply of Figure 7A;

Figure 8A through 8C illustrate various current cycle waveforms flowing through the primary winding of the power supply of Figure 7A;

Figure 9A through 9C illustrate various current cycle waveforms flowing through the primary winding of a power supply switch in accordance with the circuitry of Figures 7B or 7C;

Figure 10A is a circuit diagram of a conventional power supply and audio amplifier;

Figure 10B is a diagram of typical conduction periods of a conventional transformer secondary of the type illustrated in Figure 10A;

Figure 10C is a diagram of typical conduction periods of a transformer secondary operated in accordance with the present invention;

Figure 10D is a diagram of the peak load conduction periods of a transformer secondary operated in accordance with the present invention;

Figure 11 is an alternative embodiment of a push-pull amplifier and adapted to receive stepped voltages from the power supply;

Figures 12A, 12B and 12C are diagrams of the voltage drops across the push-pull transistors employed in the amplifier of Figure 11;

Figure 13 is another embodiment of an amplifier;

Figure 14 is a diagram of the voltage output of the amplifier illustrated in Figure 13;

Figures 15A and 15B are circuit diagrams of a preferred embodiment of the left channel of an amplifier;

Figure 16 illustrates a portion of the right channel of an amplifier; and

Figure 17 is a circuit diagram of a power supply for the preferred embodiment of the present invention, wherein various safety control features have been incorporated into the circuit.

Best mode for carrying out the invention

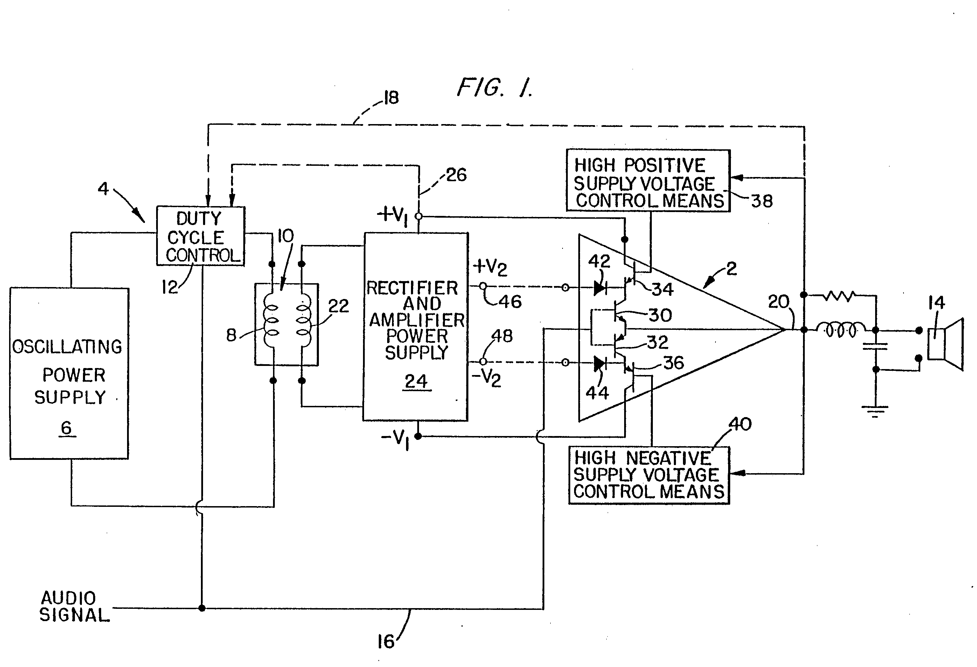

Referring to Figure 1, a highly schematic diagram of an amplifier circuit 2 and power supply circuit 4 designed in accordance with the subject invention is illustrated. Electrical energy is supplied to the system by means of an oscillating power supply 6 which may take the form of a pulse generator or a source of commercially available current such as conventional 117—125 volt, 60 cycle alternating current. The primary coil 8 of a specially designed, light weight transformer 10 is connected to the oscillating power supply 6 by means of a duty cycle control circuit 12 designed to modulate the amount of energy supplied to primary coil 8 in at least partial dependence upon a characteristic of the audio signal which is to be amplified by the system for conversion into sound by speaker 14. The audio signal characteristic may be supplied directly over the audio input signal conductor 16 or may be provided through a feedback line 18 connected with the audio amplifier output 20. As will be explained in greater detail hereinbelow, the provision of a duty cycle control 12 in the supply circuit to the primary coil 8 results in the possibility of employing a much lighter weight transformer than has been thought to be necessary heretofor.

The transformer secondary coil 22 is connected to a rectifier and amplifier power supply 24 designed to provide a direct current supply voltage to amplifier 2 which may take the form of a voltage which varies widely in amplitude in dependence upon amplitude changes in the input audio signal or the form of a relatively constant output voltage. If the latter type of amplifier power supply is employed, a voltage-level feed back line 26 may be employed to cause the duty cycle control 12 to adjust the amount of power supplied to the primary coil 8 in order to assist in maintaining constant the output voltage from amplifier power supply circuit 24.

As will also be described in greater detail below, amplifier 2 has been specially designed to permit the use of low cost, low power rated transistor components. When designed in accordance with this invention, the amplifier may be operated in a manner to minimize the amount of heat which must be dissipated by the heat sinks in the output stage of the amplifier. This operation permits further reduction in the weight of the amplifier and power system by permitting the use of smaller, lighter weight heat sinks than have previously been required by amplifiers providing comparable power output. In particular the amplifier, which may be of the Class B push-pull type, includes at least a pair of output transistors 30 and 32 for amplifying the audio signal supplied on line 16 to the respective base electrodes thereof. In one embodiment of this invention amplifier 2 includes additional transistors 34 and 36 connected in series with transistors 30 and 32, respectively, to provide higher absolute supply voltage levels to the amplifier output 20 when necessary. When these higher voltages are unnecessary, transistors 30 and 32 remain non-conductive as determined by supply voltage control means, 38 and 40, respectively. When transistors 34 and 36 are non-conductive, voltage is supplied to the collectors of transistors 30 and 32 through diodes 42 and 44, respectively, which are in turn connected to lower voltage level taps 46 and 48, respectively, of amplifier power supply 24. To further reduce the power rating requirements for transistors 30 through 36, control means 38 and 40 are designed to cause the voltage drop across the transistor pairs 30, 34 and 32, 36 to be equally shared wherever transistors 34 or 36 are conductive, respectively. The manner by which this is achieved and the beneficial results that flow therefrom will be discussed in greater detail below.

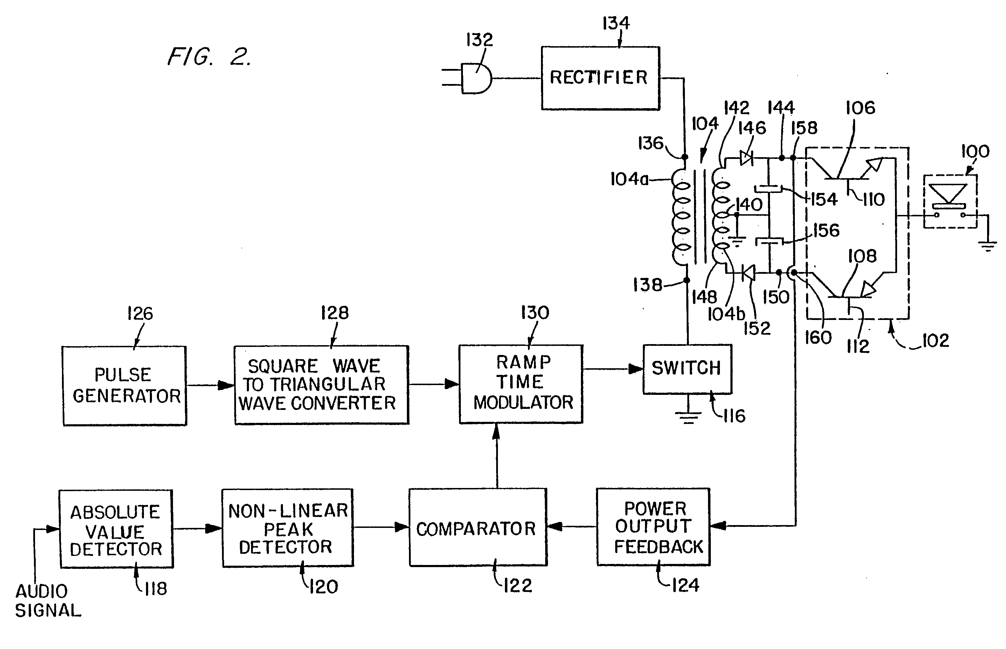

Reference is now made to Figure 2 which is a block diagram illustrating one embodiment of the present invention. There is a speaker 100 which is driven by an amplifier 102, which in turn derives its power from a transformer 104, having primary and secondary windings 104a and 104b, respectively. The speaker 100 and amplifier 102 are or may be of conventional design. As shown herein, the amplifier 102 comprises a pair of transistors 106 and 108 having signal input terminals 110 and 112, respectively, through which the audio signal is fed into the amplifier 102. Positive portions of the audio signal cause the transistor 106 to be conductive while negative portions of the audio signal cause the transistor 108 to be conductive in a manner such that an output current corresponding to the audio signal is supplied to the speaker 100. In the particular embodiment shown herein, the amplifier 102 is arranged to operate at maximum power output when plus 80 volts is applied to the transistor 106 and minus 80 volts is applied to the transistor 108.

For an appreciation of the significance of the present invention, attention is now directed to the transformer 104. In a conventional power amplifier (e.g. a 400 watt amplifier), the power transformer would weigh at least 9 kg. The reason for this is as follows. Current flow in the primary winding is equal to the voltage input multiplied by the time the voltage is applied, divided by the inductance of the transformer. For a time varying input voltage, such as a 60 Hz, 117 volt house current, analysis reveals that in order to keep the current in the primary winding (i.e. the magnetizing current) within a proper value, the inductance must be made rather large. This requires that a large, heavy transformer be used in a conventional high power amplifier.

In the embodiment of Figure 2, a power

**0 020 640**

transformer 104 can be made of a size which is a very small fraction of the size of a transformer of a conventional amplifier of comparable power output. In this particular embodiment, the transformer 104 weighs only about .2 kg, or 1/40th the weight of the transformers of typical prior art amplifiers of the same power rating. The reason for this phenomenal reduction in transformer size is that the present invention permits the inductance of the transformer 104 of the present invention to be made relatively small. When a voltage is applied across the primary winding 104a of the transformer, the magnetizing current climbs rapidly. Within several microseconds the current will have reached a high value of approximately twenty amps or so, and at this time an electronically controlled switch 116 is opened. At this point in time, an amount of energy is stored in the magnetic field surrounding the primary winding. This stored energy can be considered to be analogous to the energy stored in the electric field of a capacitor. The opening of the switch 116 causes the field to begin collapsing, which causes the energy to be transferred to the secondary winding to deliver the energy to the amplifier 102. By turning the switch 116 on and off at a relatively high frequency (i.e. 20 KHz), 20,000 voltage pulses are delivered each second to the amplifier 102.

The power delivered by the transformer 104 is controlled by controlling the time within which the switch 116 is open for each current pulse. This is accomplished by tracking the audio signal which is to be amplified by the amplifier 102 and then comparing this tracking signal to the voltage imposed across the amplifier 102. This produces a control signal which is utilized to control the duration of each current pulse delivered to the primary winding of the transformer 104. In other words, on the assumption that the switch 116 is being opened and closed at a frequency of 20 KHz, the duration of each period would be 50 microseconds. During those time periods where the power requirements of amplifier 102 are low, during each 50 microsecond period the switch 116 would be open for a relatively large fraction of that time (e.g. 25 to 35 microseconds). When the power requirements of the amplifier 102 are relatively high, the switch 116 would be open in each period for a much shorter duration.

The audio signal which is to be amplified is directed into an absolute value detector 118. This signal can have both positive and negative portions. The absolute value detector 118 provides an output when the negative portions of the audio signal become positive while maintaining these negative portions at the same magnitude relative to a zero line. The output of the absolute value detector 118 causes the negative portions of the audio signal to be inverted.

The output of the absolute value detector 118 is then directed to a non-linear peak detector 120 which is characterized in that it has a rapid response time for rapidly varying large signals, is less responsive to more slowly varying signals, and is virtually unresponsive to small signals varying about any arbitrary average level.

The output of the non-linear peak detector 120 is fed into a comparator 122. There is also a power output feedback 124 which is responsive to the voltage impressed across the power input terminals of the amplifier 102. This power output feed back 124 transmits to the comparator 122 a voltage generally proportional to the voltage at the power input terminals of the amplifier 102. The comparator 122 then "compares" the input from the non-linear peak detector 120 and the input from the power output feedback 124 to produce a control signal generally proportional to the difference between the two inputs.

This control signal generally corresponds to the increment of increase or decrease in the difference between the two input signals and is used to control the duration of the regularly timed current pulses in the primary winding 104a of the transformer 104.

There is a pulse generator 126 which functions to generate a pulsed wave of a constant voltage, where the gaps between the pulses are of approximately the same duration as the pulses themselves. The pulses are of a same frequency as the desired current pulses for the transformer 104. In the particular embodiment described herein, where the frequency of the current pulses in the transformer are 20 KHz, the output from the pulse generator 126 would be of the same frequency.

The output from the pulse generator 126 is directed to a square wave to triangular wave converter 128. This converts the square wave form from pulse generator 126 to a wave form where each pulse has the configuration of an isosceles triangle, where during the duration of each pulse, the voltage climbs at a substantially constant rate to a peak at the middle of the pulse, and then declines at a constant rate through the latter half of the pulse.

The output from the square wave to triangular wave converter 128 is transmitted to a ramp time modulator 130, and this ramp time modulator 130 also receives the control signal from the comparator 122. The modulator 130 in effect "chops off" the upper portion of the triangular wave form produced by the square wave to triangular wave converter 128.

The output of the ramp time modulator 130 is a constant voltage pulse signal having the same frequency as that of the pulse generator 126. The duration of each pulse is directly proportional to the duration of the "unchopped" bottom portion of the triangular wave form from converter 128. Thus, it can be appreciated that the duration of the pulses from modulator 130 are proportional to the magnitude of the control signal from comparator 122.

The pulses from ramp time modulator 130 are used to open and close the switch 116 in a manner that the switch 116 is closed during the duration of each of the pulses from ramp time modulator 130. Thus a pulse of relatively short duration produces a corresponding current pulse of a relatively small magnitude, since the current has such a very short time period to build up or "ramp up". It can be appreciated that as the voltage pulses from modulator 130 increase in duration, the magnitude of the current pulses in the transformer primary winding 104a increase, correspondingly, in a manner that a pulse of longest duration from modulator 130 produces a current pulse of the largest magnitude in the transformer primary winding.

Power may be supplied to the primary by means of a conventional plug 132 and bridge rectifier 134 for converting regular 110—120 volt, 60 cycle current to direct current. The bridge rectifier 134 is connected to the upper terminal 136 of the transformer primary winding 104a. The lower terminal 138 of the transformer primary winding 104a is connected to the aforementioned switch 116, which in turn is connected to ground. When the switch 116 is conductive, direct current flows through the primary 104a.

The secondary winding 104b of the transformer 104 is center tapped at 140 to ground. The upper terminal 142 of the secondary winding 104b is connected to an upper positive output terminal 144 through a diode 146 which permits only positive current to be directed to the output terminal 144. In a similar manner, the lower terminal 148 of the secondary winding 104b is connected to a lower negative output terminal 150, through a second diode 152 which permits only negative current pulses to be transmitted to the output terminal 150. There are a pair of shunt connected capacitors 154 and 156, one of which is connected to the positive output terminal 144 at a location between that terminal 144 and diode 146, and the other capacitor 156 being connected to the negative output terminal 150 at a location between that terminal 150 and diode 152. The other plates of the two capacitors 154 and 156 are both connected to ground.

In view of the foregoing description, the operation of the present invention may be understood in relation to the amplification of a typical audio signal, such as the audio signal of a musical composition. This signal will be made up of some lower frequency oscillations (fundamental tones) on which are imposed any number of higher frequency oscillations (overtones), with the amplitude of these oscillations varying over a wide range (e.g. from the sound generated by full orchestra to the quiet sound of a single woodwind instrument playing a melodic theme). With regard to the amplitude variations in the signal, although these amplitude variations might seem to the listener to be in some cases very abrupt, in actuality the very sharp amplitude changes of any great magnitude would generally take place in a time period no less than about one thousandth of a second. For example, the rise time associated with the noise generated by a very sharp percussion, such as that generated by slapping two wood blocks together is generally greater than a thousandth of a second.

Assume that an audio signal is to be amplified by the circuit of Figure 2. This signal would be directed into the two signal input terminals 110 and 112 of the amplifier 102, and would also be directed to the absolute value detector 118. As indicated previously, this audio signal is converted by the absolute value detector 118 to a direct current wave form which in turn is transmitted to the non-linear peak detector 120 to provide a "smoothed" signal to the comparator 122.

Since upon initial start up, there is no voltage generated at the output terminals 144 and 150, the feedback signal provided by the power output feedback 124 would be zero or substantially zero. Accordingly, the comparator 122 would generate a rather strong output signal to the ramp time modulator 130. The ramp time modulator 130 would in turn transmit pulses of the desired frequency to the electronic switch 116, with these pulses being of the maximum duration. In other words, the switch 116 would continue to turn "on" and "off" at the same frequency, but the duration of the "on" periods would be at a maximum. Accordingly, the current pulses passing through the primary winding 104a would ramp up to maximum amperage and thus deliver full power to the output terminals 144 and 150. Within a very short period of time, (i.e. about two hundred microseconds) the voltages applied to the power input terminals 158 and 160 of amplifier 102 would build up to the proper operating level.

At this time, the power output feedback 124, would transmit to the comparator 122 an output signal related to the voltage level at the power input terminals of the amplifier 102. Thereafter, the comparator 122 would continue to provide to the ramp time modulator 130 a control signal related to the power requirements of the amplifier 102. In other words, when the comparator 122 receives an input signal from the non-linear peak detector 120 which indicates that the amplitude of the audio signal is increasing, there will be a greater disparity between this audio-related signal and the existing signal from the power output feedback 124 so that the voltage of the control signal to the ramp time modulator 130 increases. This will in turn cause the current pulses through the primary winding 104a to increase in duration to deliver more power to the amplifier 102 and thus raise the voltages supplied at the output terminals 144 and 150. On the other hand when the amplitude of the audio signal declines, the comparator 122 would detect that the difference in the signal from the non-linear peak detector 120 and that from the power output feedback 124 is smaller, so that control signal transmitted by the comparator 122 to the modulator 130 would be of a lower voltage. This would in turn shorten the duration of the current pulses through the primary winding 104a, thus delivering less power to the amplifier 102. From the above description it can readily be appreciated that comparator 122 will in effect "track" the audio signal to maintain the voltage impressed upon the power input terminal 158 and 160 of the amplifier 102 so that these voltage levels are varied in such a manner that they remain only moderately above the power requirements of the amplifier 102. In actual practice, there would generally be a voltage drop across each of the transistors 106 and 108 of approximately five volts. In the particular embodiment shown herein, the operating components of the invention are selected so that the maximum voltage which would be applied across the terminal 158 and 160 of the amplifier 102 would be plus 80 volts and minus 80 volts.

As a further advantageous feature of the present invention, attention is directed to the two shunt connected capacitors 154 and 156. Inherent in the operation of the present invention is the feature that at any particular time, only a relatively small amount of power need be stored in the two capacitors 154 and 156 to respond to rapid increases in the power requirements of the amplifier 102. The reason for this is that the power pulses through the primary winding 104a are of such a high frequency, and the response time to increase the duration (and thus increase the power) of these current pulses in the transformer 14 can occur in such a very short time, that the transformer 14 can respond in a matter of a fraction of a millisecond to begin delivering full power to the amplifier 102. Thus, these capacitors 154 and 156 can be made with reasonably small capacity, thus creating a further savings in both weight and expense.

Another desirable feature of the present invention is the efficiency achieved. Let it be assumed that the circuit constants have been arranged to cause a constant voltage of five volts across each of the amplifier transistors 106 and 108. Let it further be assumed that the resistance of the load (i.e. the speaker 100) is eight ohms. Then let us examine three situations:

1. Where the voltage applied to the amplifier 102 is plus 25 and minus 25 volts,

2. Where the applied voltage to the amplifier is plus 35 and minus 35 volts, and

3. Where the applied voltage is plus 45 and minus 45 volts.

The power output is equal to the voltage squared divided by the resistance. For the first situation (where the applied voltage is plus 25 and minus 25 volts), there would be a drop of five volts across each transistor 106 and 108 when each is conducting, and a drop of twenty volts across the eight ohm load. The actual power output would then be twenty squared divided by eight, which gives fifty watts. The loss at the transistors 106 and 108 would be 12 1/2 watts. Therefore out of the total of 62 1/2 watts used (50 watts and 12 1/2 watts) fifty watts are actually utilized in the speaker, for an efficiency of 80%.

In the second situation (where the voltage applied across the amplifier 102 is between plus 35 and minus 35 volts), the power delivered to the speaker would be equal to thirty squared divided by eight for 112 watts. The power dissitated in the transistors 106 and 108 would be 18.75 watts, which gives an efficiency of 85.7%.

In the third situation (where the voltage applied to the amplifier 102 is plus 45 and minus 45 volts), 200 watts are actually utilized in the speaker 100 and only 25 volts dissipated in the transistors 106 and 108, for an efficiency of 88.8%.

In a conventional amplifier where the full voltage of plus 80 volts and minus 80 volts is impressed across the amplifier power input terminals at all times, the efficiencies for the three situations outlined above would be 25%, 37% and 50% respectively. Since the efficiency of the apparatus of the present invention is quite high, a relatively small amount of energy is dissipated in the transistors 106 and 108. For this reason the heat sinks for these transistors 106 and 108 can be made relatively small. It has been found that with these various weight savings, a power amplifier can be built according to the present invention with a power rating of four hundred watts, and with a total apparatus weight of only 5.5 kg.

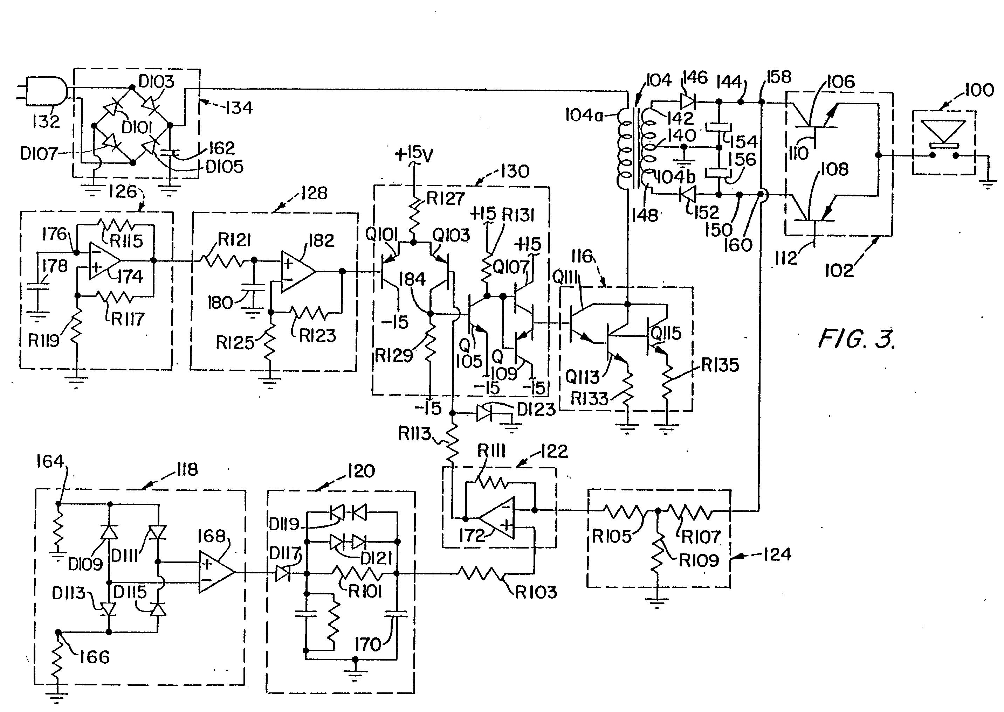

With reference to Figure 3, the circuitry of the embodiment of the present invention illustrated in Figure 2 will now be described in more detail. The plug 132 is adapted to be connected to a conventional wall socket which produces 110 to 120 volts at 60 Hz. The plug 132 connects to the bridge rectifier made up of four diodes D101, D103, D105, and D107 arranged to transmit positive d.c. current to the primary winding 104a. A small capacitor 162 (fifty to two thousand microfarads) is connected between the output of the bridge rectifier 134 and ground to prevent the D.C. output from the bridge rectifier 134 from going to zero.

The absolute value detector 118 has two input terminals 164 and 166 which are arranged to receive a signal input from a stereo player unit. The signals transmitted to terminal 164 and 166 are in turn transmitted to an operational amplifier 168 through a set of four diodes D109, D111, D113 and D115. These diodes D109—D115 are so arranged that whenever there is a relatively strong signal at one input 164 and 166 and a relatively weak signal at the other input 164 and 166, the highest value will be transmitted to the operational amplifier 168. The highest negative value will pass through the diodes D109 and D113 while the highest positive value will pass through the diodes D111 and D115. As indicated previously, the output from the operational amplifier 168 is an output signal where the negative portions of the audio signal have been made positive.

This signal passes through a diode D117 of the non-linear peak detector 120. Signals of large value are within the operating envelope of the diodes D119 and D121 and thus are passed immediately with the capacitor 170 providing a more constant output. Smaller signal variations are largely blocked by resistor R101 and diodes D119 and D121.

The output from the non-linear peak detector passes through a resistor R103 to one input terminal of an operational amplifier 172 of the comparator 122. The input to the other terminal of the operational amplifier is from the power output feedback 124. Power output feedback 124 comprises two resistors R105 and R107 connected in series to the positive input terminal 158 of amplifier 102 and a third resistor R109 connected between ground and a location between the resistors R105 and R107. These resistors R105—R109 step down the voltage from the level at the terminal 158 to less than 15 volts, which is a voltage which the operational amplifier 172 is able to handle. The operational amplifier has a resistor R111 to provide a feedback voltage.

The output from the operational amplifier 172 is transmitted through a resistor R113 to the ramp time modulator 130. A diode D123 is connected between the location of resistor R113 and the modulator 130 to pass signals from the amplifier 172 above a certain value to ground.

The pulse generator 126 may be provided as one of a number of commercially available pulse generators, such as a Fairchild US 78540. As shown herein, this pulse generator comprises an operational amplifier 174 having a pair of resistors R115 and R117 provided as feedback loops. One input terminal 176 of the operational amplifier is connected to one plate of a capacitor 178, with the other plate of the capacitor 178 being connected to ground. The other terminal of the operational amplifier 176 is connected through a resistor R119 to ground.

The square wave to triangular wave converter 128 comprises a resistor R121, which receives the voltage pulses from pulse generator 126. The resistor R121 is connected to one plate of a capacitor 180, the other plate of which is connected to ground. Capacitor 180 converts the square-wave pulsed signal from generator 126 to a triangular shaped wave. The triangular shaped wave is transmitted through one input terminal of an amplifier 182 which simply amplifies the triangular wave and transmits it to the ramp time modulator 130. The amplifier 182 has a feedback resistor R123 connected to the other input terminal thereof, and also a resistor R125 connected between the other input terminal and ground.

The ramp time modulator 130 may be a differential amplifier of conventional design such as the TL0074 from Texas Instruments Corp. As shown herein, this modulator 130 comprises two transistors Q101 and Q103 which compare the two voltages directed to the two bases of the transistors Q101 and Q103; the transistor having the lower input will conduct. The emitters of the two transistors Q101 and Q103 are connected to a positive voltage source through the resistor R127. Thus, for purposes of illustration, let it be assumed that the waveform from triangular wave converter 128 is imposed upon the transistor Q101 and the control signal from operational amplifier 172 in comparator 122 is imposed on transistor Q103. In this situation, those portions of the triangular shaped wave which are above the control signal voltage will cause transistor Q103 to conduct. The collector of transistor Q103 is connected through a resistor R129 to a negative voltage terminal, with the resistance of R127 being substantially greater than the resistance of R129. Consequently, when transistor Q103 is non-conducting, the point 184 located between transistor Q103 and resistor R129 goes negative to cause a transistor Q105 to conduct, which in turn causes the transistor Q107 to be conductive and the transistor Q109 to be non-conductive. Thus, the output from the ramp time modulator 130 is a series of pulses, with the duration of each pulse coinciding with the portion of the triangular shaped wave from converter 128 which is below the voltage control signal.

The switch 116 comprises a first transistor Q111, the output of which is connected to the bases of two parallel connected transistors Q113 and Q115. Thus, when transistor Q111 becomes conductive, it causes the two transistors Q113 and Q115 to conduct, thus permitting a current pulse to pass through the primary winding 104a of the transformer 104. When transistor Q111 becomes non-conductive in response to the termination of the pulse from ramp time modulator 130, transistors Q113 and Q115 also become non-conductive and switch 116 opens. The magnetic field created in primary winding 104a by the current pulse thereafter collapses, causing a transfer of energy between primary winding 104a and secondary winding 104b. In this manner, power is delivered to amplifier 102.

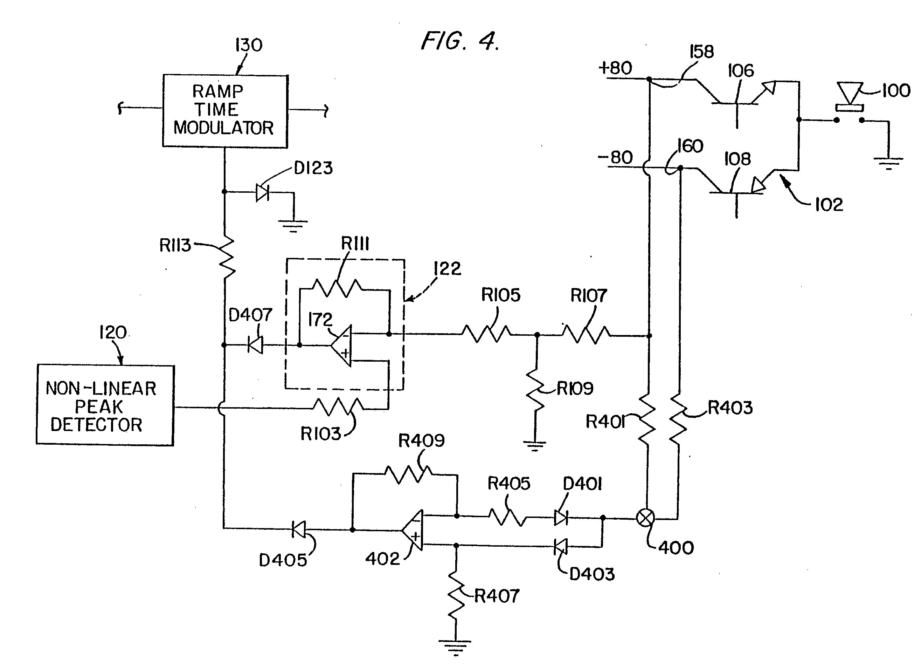

A modification of the circuitry of Figure 3 is shown in Figure 4. In Figure 4, there is shown only those portions of the circuitry of Figure 3 which are necessary for proper orientation of the components shown in Figure 4 to the other components of the present invention.

The reason for the modification of Figure 4 is that in some circumstances the voltage at the negative input terminal 160 of amplifier 102 may have an absolute magnitude that is too low relative to the voltage at the positive terminal 158. In this situation, it would be desirable to override the signal generated by the operational amplifier 172 of the comparator 122 and provide a correction signal of greater magnitude to the ramp time modulator 130. This is accomplished in the circuitry of Figure 4 in the following manner. The power input terminals 158 and 160 of amplifier 102 are connected each through a related resistor R401 and R403 to a summing junction 400. The output from the summing junction 400 is a voltage which is the algebraic sum of the voltages at the amplifier input terminals 158 and 160. Thus, if the absolute magnitude of the negative voltage is greater than the absolute magnitude of the positive voltage (minus 40 volts and plus 30 volts), the output at the junction 400 would be a negative value (e.g. minus ten volts). On the contrary, if the positive voltage at the terminal 158 has an absolute magnitude greater than that of the negative voltage at the terminal 160, the output at junction 400 will be positive.

The summing junction 400 has a first connection through a diode D401 and resistor R405 to the negative terminal of an operational amplifier 402. The summing junction 400 has a second connection through another diode D403 to the positive terminal of operational amplifier 402. The diode D401 permits only negative current to pass therethrough, while the diode D403 permits only positive current to pass therethrough. At a location between the diode D403 and operational amplifier 402, there is a resistor R407 connected to ground. There is also a resistor R409 to provide feedback to the negative terminal of the operational amplifier. The output of the operational amplifier 402 leads through a diode D405 which will only pass positive current to the resistor R113. There is also provided a diode D407 which passes positive signals from the comparator operational amplifier 172 to the resistor R113.

When the voltages at the terminals 158 and 160 are equal, the output from the summing junction 400 is zero. In those circumstances where the negative voltage at the terminal 160 is greater than the positive voltage at terminal 158, there would be a negative output from the summing junction 400 which would be transmitted through the diode D401 to the amplifier 402, which would then produce an output signal through the diode D405. If the difference between the voltages at terminal 158 and 160 is sufficiently large, this signal will override the signal from the operational amplifier 172 (which is directed through diode D407) to cause ramp time modulator 130 to increase the power of the current pulses and thus correct the difference between the absolute magnitudes of the voltages at terminals 158 and 160.

In those circumstances where the positive voltage at the terminal 158 is higher than the negative voltage at the terminal 160, the output from the summing junction 400 will be positive, and thus a positive voltage will be transmitted through diode D403 to the amplifier 402, which in turn will produce an output signal. However, since the voltage at terminal 158 is already relatively high, in most circumstances the signal from the amplifier 172 would be sufficiently large to overcome the signal from the operational amplifier 402 and provide a control signal of sufficient strength to cause ramp time modulator 130 to increase the duration of the power pulses to the transformer 104 and thus correct the disparity between the absolute magnitude of the voltages at terminals 158 and 160.

As indicated previously herein, when the amplifier of the present invention is operating as an audio amplifier, the major amplitude variations in the signals to be amplified would occur in a time period no less than approximately 1/1000 of a second. Therefore, the apparatus should be able to respond within this time period to change its power output from a low level to a relatively high level. For this reason, the frequency of the control pulses, which in turn controls the frequency of the current pulses through the transformer primary winding 104a, should be at least a thousand cycles per second, and preferably at least two thousand cycles per second. However, there are further advantages in operating the current pulses at a much higher frequency, in a range of fifteen to twenty-five thousand cycles per second (desirably about twenty thousand cycles per second). First, this permits the size of the transformer to be made quite small. Also, the frequency is at a sufficiently high level that it would not produce any undesired sounds in the normal audio range, which is normally below twenty thousand cycles per second. Further, this frequency is not so high as to be beyond the capacity of the switching circuits used.

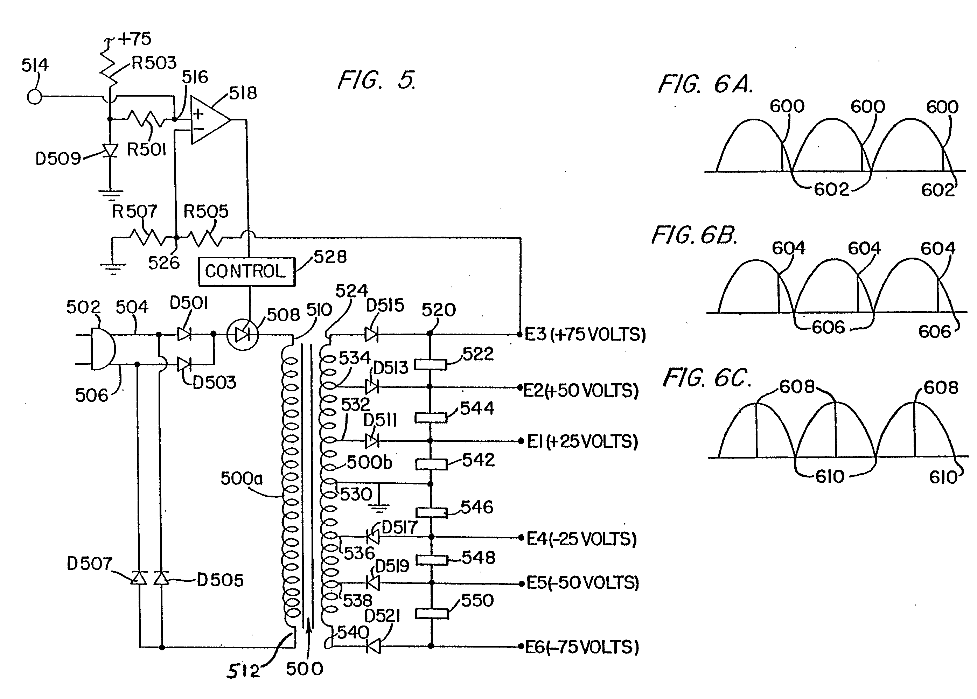

The basic concept of utilizing power output feedback in an audio amplifier transformer to control the energy transfer between the primary and secondary windings of the transformer in response to the magnitude of the audio input signal can be effectively employed in a transformer which produces a fixed voltage output across the secondary. Moreover, when a fixed output transformer is involved, the power output feedback can also be used to assist in maintaining the voltage output constant. The Figure 5 embodiment of the present invention illustrates such a system. The main power transformer 500 (i.e. magnetic field coil) has primary and secondary windings 500a and 500b, respectively.

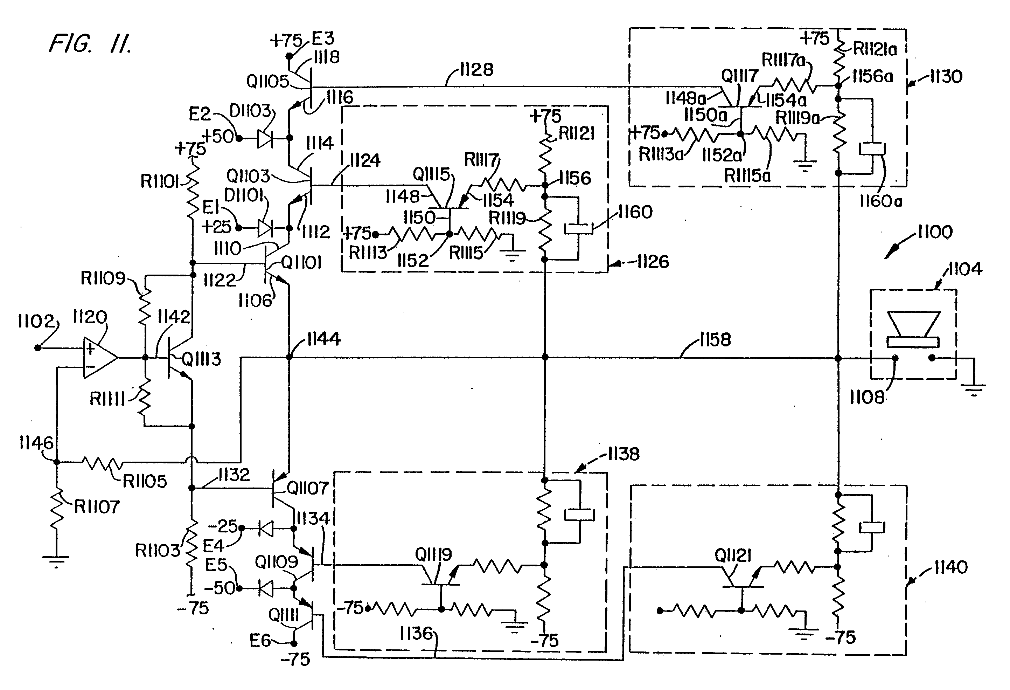

For reasons more fully explained in connection with Figure 11 below, the secondary 500b is tapped to provide plural positive and negative voltages stepped in 25 volt increments from 25 to 75 volts. The positive terminals are respectively designated E1 through E3, while the negative terminals are respectively designated E4 and E6.

The opposite ends of primary winding 500a are connected through current rectifying diodes to the two terminals of a conventional power source, indicated at 502, which can be a wall socket providing current at 60 Hertz and 120 volts. Two leads 504 and 506 from power source 502 are respectively connected through related rectifying diodes D501 and D503, and then in series with a silicon controlled rectifier 508, to the upper end 510 of transformer primary winding 500a. The leads 504 and 506 are also respectively connected through related second rectifying diodes D505 and D507 to the lower end 512 of primary winding 500a. An examination of the diodes D501, D503, D505 and D507 makes it readily apparent that these four diodes are arranged in a rectifying bridge so that on each half cycle from the power source, a positive voltage is directed to the silicon controlled rectifier 508 and thence to the upper end 510 of the transformer primary winding 500a.

Silicon controlled rectifier 508 is controlled by an audio input signal as will be explained more fully hereinbelow. The audio input signal is directed into an input terminal 514, and thence to a junction point 516. The resistors R501 and R503 are connected between junction 516 and a suitable voltage source (e.g. a 75 volt source) to provide a base voltage level of, for example, 0.7 volts. This voltage is developed by diode D509 connected from the junction of R503 and R501 to ground. The voltage is in turn directed to an operational amplifier 518. Feedback to the operational amplifier is obtained from the junction 520 of a diode D515 and capacitor 522 in the transformer secondary circuit. The point 520 is connected through two voltage dividing resistors R505 and R507 to ground. At a junction point 526 between the two resistors R505 and R507 there is a feedback connection to the operational amplifier 518. The output of operational amplifier 518 is directed to a suitable control apparatus indicated at 528. This control apparatus 528 is connected to the control terminal of silicon controlled rectifier 508 in a manner such that at higher output levels from operational amplifier 518, the rectifier 508 is caused to conduct at higher voltage levels on the latter portion of each half cycle. In like manner, when the output of the operational amplifier 518 is lower, the silicon controlled rectifier 508 is caused to fire at lower voltage levels.

The center of secondary winding 500b is tapped at 530 to ground. The upper half of the winding 500b is tapped at two intermediate locations 532 and 534 to respectively provide the positive 25 volt and 50 volt output for power terminals E1 and E2, while the upper terminal 524 of winding 500b provides the positive 75 volt output for terminal E3. In like manner, the bottom half of secondary winding 500b is tapped at intermediate locations 536 and 538 to provide the intermediate voltage levels of minus 25 and minus 50 volts at terminals E4 and E5, respectively, while the lower end 540 of the secondary winding provides the minus 75 volt output for terminal E6.

The three points 532, 534 and 524 are each connected through respective blocking diodes D511, D513 and D515 to their respective output terminals. A first capacitor 542 is provided between ground and the lower voltage output terminal (i.e. positive 25 volt terminal). A second capacitor 544 is connected between the positive 25 volt output terminal and the positive 50 volt output terminal, and the third capacitor 522 is in like manner connected between the positive 50 volt output terminal and the positive 75 volt output terminal. Capacitors 542, 544 and 522 have sufficient capacitance to compensate for any abrupt power demand from the related output terminal so as to maintain the output voltage terminals at nearly constant voltage level.

The lower half of secondary winding 500b is connected to its negative output terminals E4, E5, E6 through three blocking diodes D517, D519 and D521. Capacitors 546, 548 and 550 are respectively connected between the negative output terminals in substantially the same manner as the corresponding components for the upper half of the primary winding. However the blocking diodes D517 through D521 are reversed so as to permit only negative current to pass to the output terminals E4 through E6.

In the operation of the power supply of Figure 5, the output voltage in the winding 500b is regulated entirely by the circuitry controlling the silicon controlled rectifier 508. The SCR control circuitry 508 is in turn governed by the audio input signal in a manner such that when the input signal is of a greater amplitude, the silicon controlled rectifier 508 is caused to conduct for greater portions of each power half cycle to transmit more current to primary winding 500a. This mode of operation can best be illustrated with reference to Figures 6A, 6B and 6C.

In Figure 6A, there is a representation of the voltage delivered from power source 502 through the two diodes D501 and D503 to the silicon controlled rectifier 508. It can be seen that because of the action of the diodes D501 through D507, a positive sine wave voltage pulse is delivered to silicon controlled rectifier 508 on each half cycle. Let it be assumed that the audio input signal to the amplifier is of a relatively low amplitude, so that the power requirement of the amplifying circuit is quite low. In this condition, the silicon controlled rectifier 508 is caused to conduct only at the very end of each half cycle. The point of conduction of each half cycle is illustrated at 600, and rectifier 508 remains conductive until the current has reached zero, at point 602. Thus, it can be seen that the current is being delivered to the primary winding 500a in rather short increments of time, and at a lower voltage level.

As the audio input signal reaches a greater amplitude, silicon controlled rectifier 508 is caused to conduct at a higher voltage level for the latter part of each half cycle, as illustrated in Figure 6B. The point of conduction occurs at 604, and each cut off point is indicated at 606. It can be seen that not only is the voltage higher, but also the time increment of each current pulse is longer, so that greater power is delivered to the primary winding 500a.

Finally, in Figure 6C, there is shown the situation where the audio input signal is at a maximum amplitude, thus leading to a demand for maximum power from the transformer. In this situation, silicon controlled rectifier 508 is caused to conduct near the peak voltage at the beginning of the latter half of each half cycle, as illustrated at 608 in Figure 6C, with the cut off point being indicated at 610. Thus, it can be seen that current is being delivered at yet a higher voltage and for a longer duration during each half cycle.

As the current builds up in the primary winding 500a during the latter part of each half cycle of current, no current flows in the secondary winding 500b, because of the arrangement of the blocking diodes D511 through D521. However, at the end of each half cycle of current through the primary winding 500a, after the current is shut off, the field around 500a collapses so as to create a voltage drop across the secondary winding 500b and cause current to flow through the secondary winding to supply power to the six capacitors 522 and 542 through 550 and the six output terminals E1 through E6.

As indicated previously, when the amplitude of the audio input signal is at higher levels, the power requirements on the transformer 500 are greater. During these periods, current will flow through the primary winding 500a for longer increments of time to store more energy in the magnetic field of primary winding 500a. When the current is shut off in the primary winding at the end of each half cycle, the magnetic field in the primary winding collapses to induce a flyback voltage across the secondary winding 500b. The diodes D511 through D521 are arranged so that current flows through the secondary winding to charge the capacitors 542, 544, 522, 546, 548 and 550 to maintain the voltage at the power terminals E1 through E6 at the proper level.

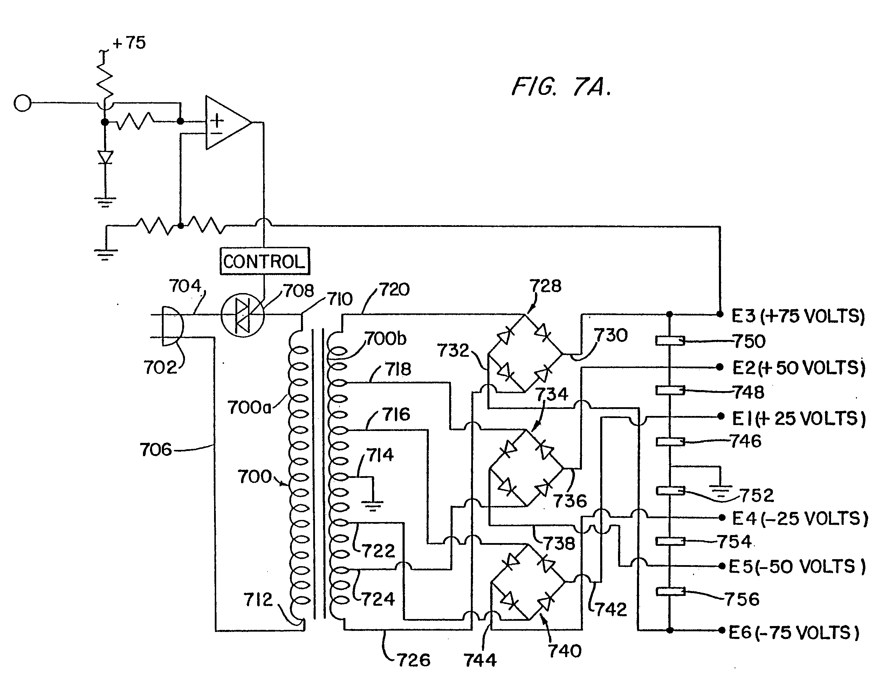

Figure 7A illustrates another embodiment of a stepped voltage power supply constructed in accordance with the present invention. As in the Figure 5 embodiment, there is a power source such as wall plug 702 including two leads 704 and 706. Lead 704 is connected to a triac 708. The opposite side of the triac 708 connects to the upper end 710 of primary winding 700a in transformer 700. The other lead 706 of power source 702 connects to the lower end 712 of primary winding 700a.

The triac 708 serves a function similar to that of the silicon control rectifier 508, except that triac 708 conducts on both positive and negative half cycles of the current from power source 702. Switching circuitry controls the triac 708 in a manner such that it conducts during the latter portion of each half cycle for longer or shorter periods of time, depending upon the power requirements of the amplifier. This switching circuitry is substantially the same as the circuitry which switches silicon controlled rectifier 508 in the Figure 5 embodiment of the invention, and thus the circuit components will not be described in further detail.

The secondary winding 700b of transformer 700 is tapped to ground at its center point 714. The upper half of secondary winding 700b is tapped at two intermediate locations 716 and 718 to provide the positive 25 volt and 50 volt outputs for the power terminals E1 and E2. A connection 720 to the upper end of winding 700b provides the positive 75 volt output for power terminal E3. In like manner, the bottom half of the secondary winding is tapped at three equally spaced locations, 722, 724 and 726 to respectively provide the negative 25, 50 and 75 volt outputs E4, E5 and E6.

The positive and negative 75 volt leads 720 and 726 are attached at opposite ends to a first bridge rectifier, generally indicated at 728. The positive output of bridge rectifier 728 is connected by lead 730 to the positive 75 volt power terminal E3, and the negative output of the bridge rectifier 728 is connected to the negative 75 volt power output E6 through lead 732. The positive and negative 50 volt leads 718 and 724 are connected to the opposite ends of a second bridge rectifier 734. The positive output terminal of bridge rectifier 734 is connected by lead 736 to the positive 50 volt power terminal E2, while the negative output from the bridge rectifier 734 is connected through lead 738 to the negative 50 volt power terminal E5. Finally, the positive and negative 25 volt leads 716 and 722 are connected to opposite ends of a third bridge rectifier 740. The output leads 742 and 744 of bridge rectifier 740 are respectively attached to the positive and negative 25 volt power terminals E1 and E4.

As in the Figure 5 embodiment, six capacitors, designated 746 through 756, are provided between the power output terminals E1 through E6 to compensate for any abrupt power demand on the related output terminal so as to maintain the output voltage terminals at nearly constant voltage level.

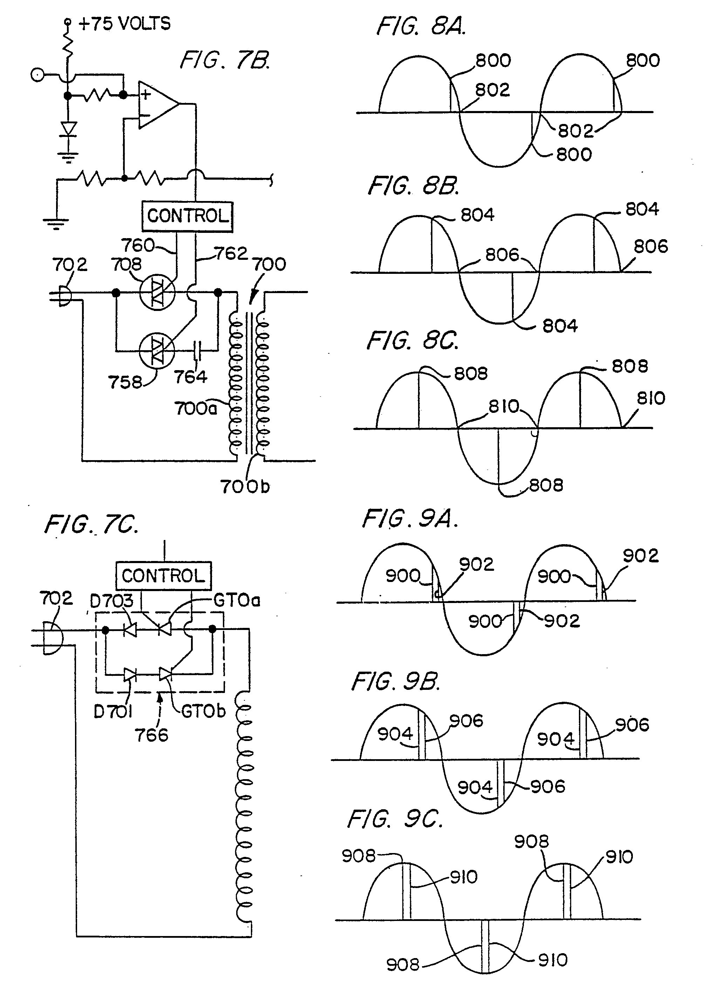

To describe the operation of the embodiment of Figure 7A, reference is made to Figures 8A, 8B and 8C. The current through primary winding 700a is not rectified and is thus an alternating current. The triac 708 is caused to conduct in the latter half of each half cycle, whether it be a positive or negative half cycle. When the power requirements of the amplifier are low, the control apparatus acts to cause triac 708 to conduct for only a very short time period at the end of each half cycle. This is illustrated in Figure 8A, where the point of conduction of each half cycle is illustrated at 800. Triac 708 remains conductive until the voltage has reached zero at point 802. Thus, it can be seen that current is being delivered to the primary winding in rather short increments of time, and at a lower voltage level.

As the control signal reaches a greater amplitude, the triac 708 is caused to conduct at a higher voltage level for the latter part of each half cycle, as illustrated in Figure 8B, where the point of conduction is indicated at 804, and each cutoff point is indicated at 806. It can be seen that not only is the voltage higher, but also the time increment of each current pulse is longer, so greater power is delivered to primary winding 700a.

Finally, in Figure 8C, there is shown the situation where the input signal is at a maximum amplitude, thus providing for maximum power requirements. In this situation, triac 708 is caused to conduct near the peak voltage at the beginning of the latter half of each cycle, as illustrated at 808, with the cutoff point being indicated at 810.

Current flows in the secondary winding 700b simultaneously with the flow of current in 700a, with the current in 700b also being an alternating current. With regard to the flow of current through the two 75 volt leads 720 and 726, since this current flows through the rectifying bridge 728, the output to the power terminal E3 is always positive, while the output to the terminal E6 is always negative. In like manner, current is directed from the intermediate terminals 716, 718, 722 and 724 through the two bridge rectifiers 734 and 740 to provide positive current to the output terminals E2 and E1 at the positive 50 and 25 volt levels, and to provide negative current to the power output terminals E5 and E4 at the negative 50 and 25 volt levels, respectively.

It has been found that by using the power supply circuitry of the present invention, the transformer can be made relatively small and still provide adequate power. For example, the transformer in the present invention can be made from 1/4 to 1/10 the size of the transformer in a conventional audio amplifier of comparable power rating, with one hundred and seventy five windings in the primary and two hundred in the secondary.

It is sometimes desirable to adjust the cutoff point of current flow through transformer primary 700a in order to more precisely control the characteristics of the energy transfer across the transformer windings during each half cycle of current from the power source. For example, shutoff of the primary current prior to the zero crossover voltage point in the current waveform eliminates idling currents in the primary winding during the remaining portion of the waveform half cycle. Accordingly, Figures 7B and 7C illustrate two modifications to the switching circuitry of Figure 7A, both of which modifications enable the transformer primary winding 700a to receive current during more narrowly defined portions of the power cycle.

In Figure 7B, a second Triac 758 is connected in parallel with Triac 708. A control apparatus as previously described in connection with Figure 5 controls the operation of Triacs 708 and 758 respectively via leads 760 and 762. A capacitor 764 is connected in series with Triac 758 and acts to periodically shunt Triac 708. The circuit of Figure 7B operates as follows. In response to an audio input signal, output from the control apparatus causes Triac 708 to conduct at some point during each positive and negative half cycle of the current from power source 702. At a later predetermined time the output from the control apparatus causes triac 758 to conduct, whereupon current is diverted from Triac 708 and begins to flow through capacitor 764. Triac 708 shuts off but current continues to pass through Triac 758 and capacitor 764 to transformer primary 700a until the voltage buildup in capacitor 764 reaches a level sufficient to turn Triac 758 off, thus ending current flow through the transformer primary. Capacitor 764 is very small in order to limit the conductive state of Triac 758 to a short period of time.

Figure 7C illustrates a second modification of the embodiment of Figure 7A where the single triac 708 is replaced by a switching apparatus indicated generally at 766. A pair of GTO SCR's are connected in parallel with one another. One GTO, designated GTOb, conducts on positive half cycles and a second GTO, designated GTOa, conducts on negative half cycles. Blocking diodes are provided at D701 and D703. Each GTO becomes conductive at a predetermined voltage, as provided by the control means, and becomes non-conductive, as provided by the control means, within a predetermined control time period, preferably one millisecond.

Figures 9A, 9B and 9C illustrate the manner of switching common to both the Figure 7B and 7C modifications. At low power requirements the current flow begins at 900 and ends at 902 near the latter part of the last part of each half cycle. At intermediate power requirements, the on-off switching occurs earlier in the latter half of each half cycle, illustrated in Figure 9B at 904 and 906. At peak power requirements, the switching occurs near the peak of each half cycle, illustrated in Figure 9C at 908 and 910.

With this arrangement, the transformer can be made yet smaller.

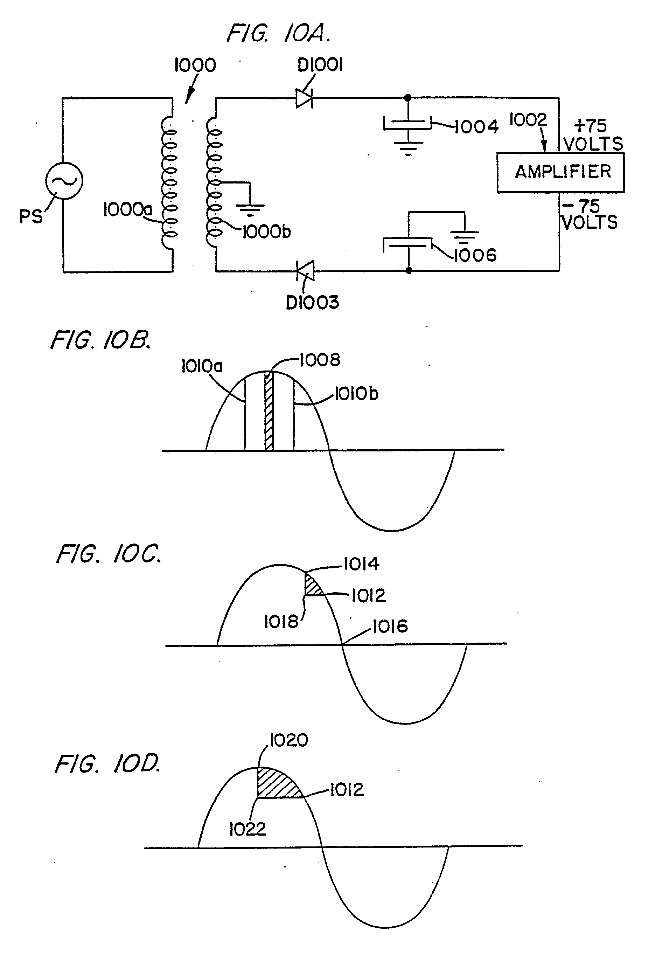

For purposes of clearly demonstrating the advantage of the various duty cycle controlled power supply embodiments discussed above, reference is made to Figure 10A, which illustrates the basic configuration of a conventional amplifier power supply. Conventional 117—125v 60 cycle AC is supplied from PS to the primary winding 1000a of a transformer 1000. The secondary winding 1000b of transformer 1000 has its upper end connected through a diode D1001 to the upper terminal of the amplifier 1002. The lower terminal of the secondary winding 1000b is connected through a second diode D1003 to the lower terminal of amplifier 1002. Upper and lower capacitors 1004 and 1006 respectively maintain the voltage imposed upon the amplifier 1002 at a substantially constant value. Normally, the supply voltage has a peak voltage input of approximately 169 volts. Let it be assumed that the input voltage imposed at the upper terminal of the amplifier 1002 is designed to be plus 75 volts and the voltage at the lower terminal is minus 75 volts. The center of the secondary winding 1000b is normally tapped to ground.

An audio sound typically has peak power requirements of relatively short duration and average power requirements of longer duration which are possibly 1/20th of the peak power requirement. Thus, most of the time the amplifier is operating at only 1/10th to 1/20th of full power. To understand the implication of this fact, reference is made to Figure 10B illustrating the sine wave of incoming voltage supplied to the primary of a conventional audio amplifier transformer connected to receive conventional 117 to 125v alternating current. The turns ratio of the primary and secondary winding of the conventional transformer is such that with the primary conducting at least some current throughout the entire sine wave of the incoming voltage, the peak voltage generated in the secondary is just slightly larger than the plus 75 and minus 75 volt level required by a conventional audio amplifier. When the amplifying component of the amplifier is demanding only average power, current flows in the secondary winding for only a very short period of time at the very peak of the sine wave of the input voltage. This time period is indicated at 1008 in Figure 10B. When there are peak power requirements, there is an immediate drain on the conventional storage capacitors 1004 and 1006 of the power supply to lower their voltage levels slightly, and the result is that the secondary winding is conducting for a longer time period, so that the conducting portion of the sine wave of Figure 10B is broadened out to, for example, lines indicated at 1010a and 1010b. It should be noted that since the two lines 1010a and 1010b are spaced further apart, the voltage produced in the secondary winding 1000a is moderately down from the peak voltage delivered at 1008.

In designing a transformer suitable for use in a conventional amplifier power system as described above, careful consideration must be given to accommodating the idling current in the primary. Idling current is the current which flows in the primary when no current is flowing in the secondary. In a transformer having a small number of windings in the primary and thus a small inductance, the primary idling current may become large enough to cause the transformer to heat up to an undesired extent. This fact dictates the use of a primary coil having a large number of windings.

A suitable audio amplifier transformer of conventional design must also be capable of accommodating a relatively large current flow through the primary and secondary coils in order to handle peak power demands. Thus the wire forming the coils must be of sufficient diameter to allow the transformer to deliver high current at peak loads, without too much internal resistance. The result is a very large, heavy transformer having a large number of windings to keep the inductance in the primary sufficiently high, and relatively thick wire to keep the resistance relatively low in spite of the rather long length of wire in the transformer.

In contrast with a conventional power supply transformer, a transformer designed for use in the duty cycle controlled power supply of the present invention will normally be formed with a higher secondary to primary turns ratio than is conventional in non-duty cycle controlled transformers employed in commercial amplifier power supply circuits. With such a turns ratio, the point on the sine wave input to the primary at which current would stop flowing in the secondary can be made to occur well down the back slope as illustrated at point 1012 of Figure 10C. Without duty cycle control the power supply equipped with such a transformer would be supplying voltage substantially above the desired plus 75 and minus 75 volt levels normally required by conventional audio amplifiers. With duty cycle control, no current will flow in the primary of the transformer when the duty cycle switching element is open except for very small leakage currents allowed by the solid state switching element when in the open condition. These leakage currents can be ignored for purposes of this discussion. The switching element remains in a non-conducting position until the voltage in the primary drops to a point 1014 just above the 1012 level. Then, current flows in the secondary between points 1014 and 1012. If the switching element is a self-commutating SCR, the switching element will remain in a conducting state down to point 1016 but no current will be flowing in the secondary from point 1012 to point 1016 since the diodes connecting the storage capacitor's in the power supply to the transformer secondary will become back biased.

Causing current flow in the secondary of a duty cycle controlled power supply during the time between points 1014 and 1012 of Figure 10C would appear at first observation to be a little more inefficient than causing secondary current flow in a conventional amplifier as represented by 1008 in Figure 10B. This is because the capacitors 1004 and 1006 only want to accept current at the 75 volt level. Thus, there are some resistance losses which occur in the duty cycle controlled transformer, these being represented by the shaded triangle between points 1012, 1014 and 1018 in Figure 10C. However, a duty cycle controlled transformer can get by with many fewer turns (only á small fraction of the turns in a conventional transformer), so that the length of wire in the transformer is reduced. This reduces the internal resistance of the transformer proportionately.

Let it now be assumed that the smaller duty cycle controlled transformer is operated at peak power requirements as is illustrated in Figure 10D. In this situation the switching element moves the "switch on" point further up the sine wave, which would be at a maximum of approximately point 1020 near the peak of the sine wave. Let it further be assumed that the capacitors 1004 and 1006 are sufficiently large so that they are maintaining voltages of plus 75 and minus 75 volts pretty much at that level. The voltage generated in the secondary at point 1020 would be substantially high than the plus 75 volt level (possibly 90 volts), ignoring losses in the transformer. Therefore, the voltage difference represents the losses in the transformer itself. These losses are represented in the shaded triangle between points 1012, 1020 and 1022 in Figure 10D. Due to the fact that peak power is rarely required by audio amplifiers for more than a very short time, the somewhat greater losses represented by Figure 10D can be tolerated in order to obtain the compensating gains of cutting off idling currents during the first part of each cycle of the conventional A.C. input sine wave. When the switching element in the primary coil includes means for turning off the current flow in the primary coil prior to return of the waveform to a zero voltage (such as is illustrated in Figures 9A through 9C), even greater reduction in idling current losses can be achieved.

In summary, most of the time an amplifier power supply is operating in the low power mode, as shown in Figure 10C. Accordingly, the smaller duty cycle controlled transformer of the present invention can operate with about the same efficiency as the much larger prior art transformer. This is due in part to the number of primary and secondary turns being cut down substantially, thereby permitting the transformer wire to be much shorter and thus offering less resistance in the transformer itself. This lessened resistance makes the existence of the idling current in the latter portion of each half cycle more tolerable. When higher power levels are required, there is potential for greater inefficiency. However, this is offset by the low internal resistance of the transformer, and in any case it is possible to live with these higher inefficiencies for a short period of time, since they will not be large enough to overheat the transformer.

The following table includes the results of testing several different transformer designs wherein the transformers were tested by connecting the 50 volt output terminals of the secondary to two 150 watt light bulbs. The output of the secondary winding was maintained at 300 watts. Temperature was measured at the top center portion of the transformer.

TABLE I

| Transformer number | Turns in primary | Turns ratio sec/prim. | Wire size | Primary inductance | Resistance primary/sec. | Temp C° after 21 min. |
|---|---|---|---|---|---|---|
| 9 | 149 | 0.66 | #18 & #17 | 58.6 | 485/733 | 31° |
| 8 | 131 | 0.82 | #18 & #17 | 52.7 | 400/789 | 45° |
| 7 | 113 | 1.03 | #18 & #17 | 32.2 | 335/812 | 62° |
| 1 | 90 | 1.14 | #18 | 33.7 | 330/888 | 64° |
| 4 | 113 | 1.14 | #18 · | 32.3 | 330/993 | 67° |
| 6 | 113 | 1.14 | #18 & #17 | 33.7 | 330/888 | 71° |
| 3 | 141 | 1.14 | #20 | 58.1 | 538/1560 | 75° |
| 2 | 113 | 1.14 | #19 | 43 | 452/1470 | 84° |
| 5 | 177 | 1.14 | #20 | 97 | 800/2340 | 107° |

The results of these tests indicate that a preferable duty cycle transformer designed for operation in a power supply built in accordance with this invention would be a transformer having a secondary to primary turns ratio below 1.0 with a primary inductance above 30 millihenries and a coil wire gauge diameter above No. 18 when the transformer is used to produce a maximum ±75 volt D.C. output from conventional 117—125 volt, 60 cycle alternating current.

Figure 11 depicts an amplifying apparatus 1100 designed to utilize the stepped voltage power supply illustrated in Figures 5 and 7A—7C. A signal voltage is provided at 1102, and the output of the amplifier is connected through a load (shown herein as a speaker 1104) to ground. The apparatus employs two sets of transistors arranged in push-pull relationship, with each set being connected in series. The first set Q1101, Q1103 and Q1105 are NPN transistors, and these are used to amplify positive portions of the input signal. The other set of transistors Q1107, Q1109 and Q1111 are PNP transistors and are used to amplify negative portions of the input signal. In the following description, the overall operation of the first set of transistors Q1101, Q1103, Q1105 will be described in detail, with the understanding that the same description would apply to the operation of Q1107, Q1109 and Q1111 with respect to the negative portions of the signal.

It will be noted that the emitter electrode 1106 of Q1101 is connected to a power output terminal 1108 of the load 1104, and the collector electrode 1110 of Q1101 is connected through a diode D1101 to a D.C. voltage source E1 having a magnitude of plus 25 volts. The emitter electrode 1112 of the second transistor Q1103 is connected to the collector electrode 1110 of Q1101, and the collector electrode 1114 of the transistor Q1103 is connected through a second diode D1103 to an intermediate D.C. voltage source E2 having a magnitude of plus 50 volts. Finally, the third transistor Q1105 has its emitter electrode 1116 connected to the collector electrode 1114 of Q1103, and its collector electrode 1118 is connected directly to a higher D.C. voltage source E3, which is shown as having a magnitude of plus 75 volts.

As discussed previously herein, under the topic heading "Background of the Invention", various arrangements of series coupled transistors, with the stepped voltage sources of increasing magnitude are shown in the prior art. It is believed that a better understanding of the operating features of the present invention will be achieved by preceding a detailed description of the present invention with a general discussion of the general mode of operation of prior art devices using an arrangement of series connected transistors with stepped voltage sources.

To discuss generally the prior art modes of operation, when the signal voltage is relatively small (e.g. below 25 volts) only the first transistor Q1101 would be conductive, and all of the power would be derived from the 25 volt power source E1. The obvious advantage is that there is less voltage drop across the transistor Q1101 and thus an increase in efficiency.

When the signal voltage closely approaches the value of the first voltage level, in prior art devices the signal voltage is then applied in some manner to the base of the transistor Q1103 to make it conductive, so that the power is derived from the 50 volt source E2, with the 25 volt source being blocked out by the diode D1101. While the signal is fluctuating between the 25 volt and 50 volt level, substantially all or at least the major portion of the voltage drop is taken across the second transistor Q1103.

In like manner, when the signal voltage rises above the 50 volt level, the voltage signal is applied to the base of the transistor Q1105 to make it conductive and thus derive power from the 75 volt power source E3. Also, with the signal voltage fluctuating between the 50 and 75 volt level, substantially all, or at least the major portion of, the voltage drop is taken across the third transistor Q1105. Thus, with regard to the prior art devices, each of the transistors must be made with the capability of withstanding the voltage drop imposed across the transistor at the current levels existing at the various voltage levels.

Reference is again made to Figure 11. To discuss specifically the present invention, it will be noted that the signal input terminal 1102 is connected through an operational amplifier 1120 to a biasing transistor Q1113. The collector electrode of transistor Q1113 is connected through a resistor R1101 to a plus 75 volt source. The base electrode 1122 of the transistor Q1101 is connected at a junction point between the resistor R1101 and transistor Q1113 to provide a forward bias to the transistor Q1101. The base electrode 1124 of the second transistor Q1103 is connected to a first switch and control means, indicated at 1126, and the base electrode 1128 of the third transistor Q1105 is connected to a second switch and control means, indicated generally at 1130.

The second set of transistors Q1107, Q1109 and Q1111 are similarly connected. Thus, the biasing transistor Q1113 is connected in series with a resistor R1103 to a minus 75 volt source, with the base electrode 1132 of transistor Q1107 connected to a terminal between transistor Q1113 and resistor R1103. The respective base electrodes 1134 and 1136 of transistors Q1109 and Q1111 are respectively connected to a third switch and control means 1138 and a fourth switch and control means 1140. Negatively stepped voltage sources E4, E5 and E6 are provided in the same manner as the sources E1, E2 and E3.

As shown herein, the input from 1102 is through an operational amplifier 1120 to the base 1142 of biasing transistor Q1113. There is a feedback from the output junction 1144 between the transistors Q1101 and Q1107 back through the resistors R1105 and R1107 to ground. From the junction 1146 intermediate transistors R1105 and R1107, there is a feedback connection back to operational amplifier 1120. The resistors R1109 and R1111 provide an initial biasing voltage to the transistors Q1101 and Q1107, respectively.

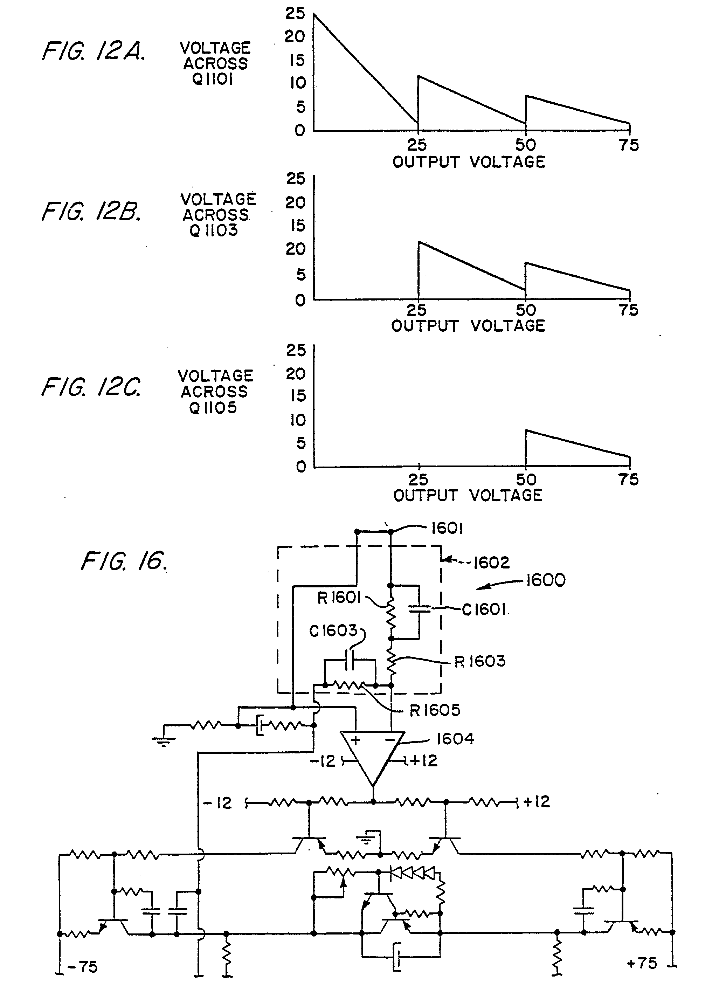

The general function of each of the switch and control means 1126, 1130, 1138 and 1140 is to cause a related transistor to become conductive at the appropriate time and then to apportion the voltage drop across the related transistor so as to minimize the power which must be dissipated by any transistor at any particular time. The manner in which this is accomplished can best be described with reference to the graphs of Figures 12A, 12B and 12C.

In Figure 12A the voltage drop across the first transistor Q1101 is plotted against the output voltage. Let it be assumed that the signal voltage has climbed to a low level of five volts. This voltage is applied to transistor Q1101 to cause it to become conductive to transmit current from the positive 25 volt source E1 through transistor Q1101 and to the output terminal 1108. Thus the voltage at output terminal 1108 will be approximately 5 volts, and the voltage drop across transistor Q1101 will be approximately 20 volts. As the signal current increases to a value closer to the 25 volt level, the voltage level at output terminal 1108 increases, while the voltage drop across transistor Q1101 decreases.

When the signal voltage comes within one or two volts of the 25 volt level, the first switch and control means 1126 becomes operative and directs current to the base electrode 1124 of transistor Q1103 at a voltage level intermediate the level of the output voltage and the value of the positive fifty volt source E2. The graphs of Figure 12A and 12B illustrate this relationship in a somewhat idealized manner, where the first switch and control means 1126 functions to apply a voltage to base electrode 1124 consistently mid-way between the output voltage and the plus 50 volt level at E2, so that the voltage drop across the two transistors Q1101 and Q1103 remain substantially equal for all output voltages between 25 and 50 volts. In the actual embodiment shown herein, the apportioning of the voltage drop across transistors Q1101 and Q1103 would depart moderately from this idealized situation.

When the signal voltage comes very close to the 50 volt level, then the second switch and control means 1130 makes the third transistor Q1105 become conductive and also transmits base current to the base electrode 1128 of Q1105 at a sufficiently high voltage so that only a portion of the total voltage drop is across the transistor Q1105. In like manner, the first switch and control means 1126 continues to supply current to the base electrode 1124 of transistor Q1103 so that the voltage drop across Q1103 is within its apportioned share of the total voltage drop across the three transistors Q1105, Q1103 and Q1101.

Again, the somewhat idealized situation is shown in Figure 12A, 12B and 12C, in that with the output voltage between 50 and 75 volts, the voltage drop is equally apportioned among all three transistors. In actual practice, the apportioning would not be that precise.

The manner in which the four switch and control means 1126, 1130, 1138 and 1140 operate will now be described. Since each of the four switch and control means are substantially identical, only the first means 1126 will be described in detail.

In the first switch and control means 1126, there is a control transistor Q1115 having its collector electrode 1148 connected to the base electrode 1124 of the second power transistor Q1103. The base electrode 1150 of transistor Q1115 is attached to a junction point 1152 between two voltage dividing resistors R1113 and R1115. The other end of the resistor R1113 is connected to a positive 75 volt terminal, while the other end of resistor R1115 is connected to ground.

The emitter electrode 1154 of the transistor Q1115 is connected through a resistor R1117 to a juncture point 1156 between two voltage dividing resistors R1119 and R1121. The other end of resistor R1121 is connected to a positive 75 volt source, while the other end of resistor R1119 is connected to the main output line 1158 leading to the output terminal 1108. A capacitor 1160 is connected in parallel with the resistor R1119 to alleviate rapid voltage changes across the resistors R1119 and R1121.

As discussed previously herein, it is desirable to have transistor Q1103 become conductive when the signal voltage (and consequently the output voltage which should be substantially identical to the signal voltage) reaches a level just below the 25 volt level. It is also desirable to have the current supplied to the base electrode 1124 of the transistor Q1103 at a voltage level approximately intermediate the output voltage and the next stepped voltage· in the power source, which is the 50 volt power source E2. Accordingly, when the output voltage reaches approximately the 25 volt level, it is desired that the base electrode 1124 of transistor Q1103 have a current delivered thereto at a voltage approximately midway between 25 and 50 volts (e.g. approximately 37 1/2 volts).

The value of the resistances R1113 and R1115 are selected so that when little or no base current is flowing to the base electrode 1150 of the transistor Q1115 the voltage at junction point 1152 is approximately 37.5 volts. The values of the two resistors R1119 and R1112 are so selected that when the output voltage comes within one or two volts of the voltage of the lowest power terminal (i.e. 25 volts) the voltage at junction 1156 is approximately 38.2 volts so as to apply a forward bias to the emitter electrode 1154 of the transistor Q1115 to cause transistor Q1115 to conduct and transmit base current to the base electrode 1124 of the transistor Q1103. Since the collector electrode 1114 of transistor Q1103 tends to follow the voltage of base electrode 1124 within a fraction of a volt, the immediate effect would be to bring the voltage at the emitter electrode 1112 of Q1103 to approximately 37.5 volts. Thus, with an output voltage of approximately 25 volts, the voltage drop across transistor Q1103 would be approximately 12.5 volts, and the voltage drop across transistor Q1101 would be 12.5 volts, thereby causing the power dissipated to be shared equally by Q1101 and Q1103.

As the signal voltage increases in the 25 volt to 50 volt range, the voltage at junction point 1156 likewise increases so as to tend to drive the voltage at the emitter electrode 1154 of transistor Q1115 upwardly. This causes an increase in current to the base electrode 1150 of Q1115, thus raising the voltage of junction point 1152 to a level closer to the voltage of emitter electrode 1154 and also causing transistor Q1115 to be more conductive so that greater current is supplied to the base electrode 1124 of transistor Q1103 at yet a higher voltage. The effect of this is to raise the voltage at emitter electrode 1112 of transistor Q1103 even higher (i.e. closer to the 50 volt level). Thus, as the output voltage increases from the 25 volt level toward the 50 volt level, the voltage drop across transistor Q1103 diminishes to apportion the voltage drop between the transistors Q1103 and Q1101

By the time the signal voltage reaches the second power source increment level (i.e. the 50 volt level), substantially all of the voltage drop is across the load, and there is very little voltage drop across the two transistors Q1101 and Q1103. At this time, the second switch and control means 1130 becomes operative to cause the third transistor Q1105 to become conductive. Because this is accomplished in substantially the same manner as in the first switch and control means 1126, the operation of the means 1130 will be summarized only briefly.

It can be seen that there is a control transistor Q1117 having a collector electrode 1148a connected to the base electrode 1128 of transistor Q1105. There are a pair of voltage dividing resistors R1113a and R1115a producing a voltage level of approximately 62.5 volts at juncture point 1152a. Also, the two voltage dividing resistors R1119a and R1121a are arranged such that when the output voltage reaches a level just below the 50 volt level, the voltage at junction point 1156a is approximately 63.2 volts.

Thus, when the output voltage comes quite close to the 50 volt level, a forward bias is applied between the emitter electrode 1154a of transistor Q1117 and base electrode 1150a to cause the transistor Q1117 to conduct, thereby supplying base current to the base electrode 1128 of transistor Q1105 to cause transistor Q1105 to conduct. As soon as Q1105 becomes conductive, the voltage of the emitter electrode 1116 of Q1105 rises to a level close to that of base electrode 1128 of Q1105 (i.e. approximately 63.2 volts). This causes the diode D1103 to block off the 50 volt power source so that all of the power is derived from the plus 75 volt power source.

When the output voltage is slightly above 50 volts, the voltage at which current is being delivered through transistor Q1115 to the base electrode 1124 of transistor Q1103 is intermediate between the output voltage and the voltage of the current to the base electrode 1128 of transistor Q1105. Thus, the voltage drop from the 75 volt source to the level just above the 50 volts being delivered to output terminal 1108 is apportioned between the three transistors Q1101, Q1103 and Q1105. As the output voltage increases further toward the 75 volt level, the voltages at the junction points 1156 and 1156a increase proportionately to raise the voltage of the currents respectively delivered to the base electrodes 1124 and 1128 of transistors Q1103 and Q1105, thus increasing the voltage level at the respective emitter electrodes 1112 and 1116 of transistors Q1103 and Q1105. Consequently, the voltage drop across the three transistors Q1101, Q1103 and Q1105 continues to be apportioned between the three transistors. As indicated previously, the apportioning illustrated in the graphs of Figures 12A, 12B and 12C is somewhat idealized, and the actual voltage drops will depart somewhat from the precisely equal apportionment.

The operation of the third and fourth switch and control means 1138 and 1140 is substantially the same as that of the first and second switch control means 1126 and 1130 respectively, except that the means 1138 and 1140 operate on the negative portions of the input signal. Accordingly, the operation of the means 1138 and 1140 will not be described in detail.

It is sufficient to note that transistor of switch control means 1138 is designated Q1119 while the control transistor of switch control means 1140 is designated Q1121. The control transistors Q1119 and Q1121 operate in substantially the same manner as corresponding transistors Q1115 and Q1117 to make the power transistors Q1109 and Q1111, respectively, conductive at the proper negative voltage levels. Transistors Q1119 and Q1121 also control the voltage level of the emitter electrodes of transistors Q1109 and Q1111 to apportion the voltage drop across the three transistors Q1107, Q1109 and Q1111.

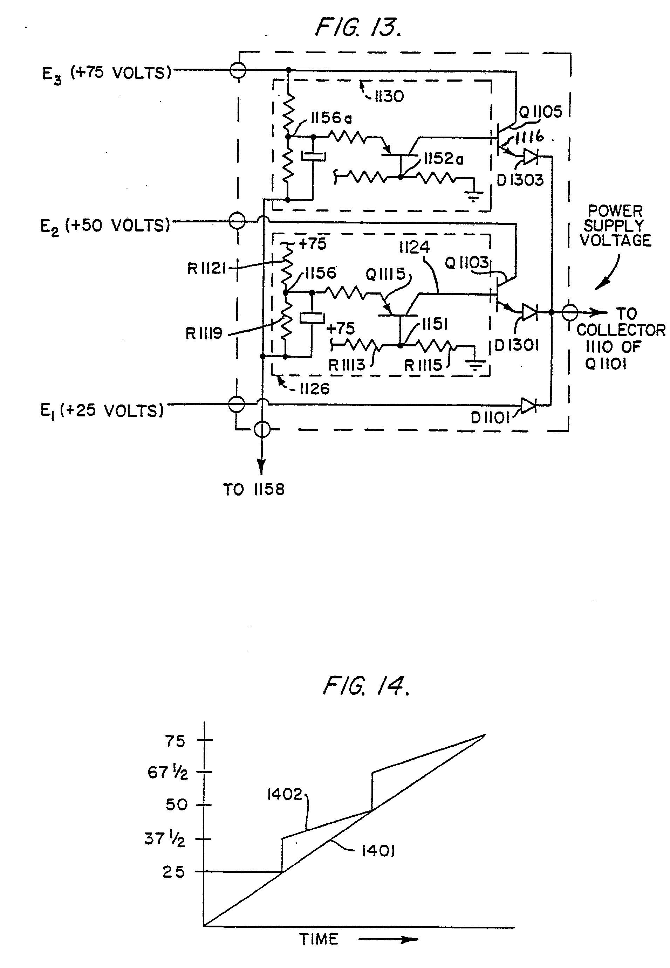

Referring now to Figure 13, an alternative arrangement of the output stage transistors and transistor control means for use in an audio amplifier of the type illustrated in Figure 11 is disclosed. In particular, those components in Figure 13 which are identical with the components of Figure 11 have been identified by the same reference numerals. The voltage dividing resistors R1115 and R1113 are selected so that the voltage at 1152 will be 37 1/2 volts when the voltage at 1156 reaches approximately 38 volts as described above, thereby causing transistor Q1115 to conduct. This in turn causes the emitter of transistor Q1103 to jump up to the 37 1/2 volt level, raising the input voltage to transistor Q1101 to 37 1/2 volts. Diode D1101 now operates to block off the 25 volt power source. As the output signal on line 1158 climbs toward 50 volts, the voltage at 1156 also climbs upwardly toward the 50 volt level. By the time the audio signal reaches the 50 volt level, the voltage at 1156 will also have reached 50 volts, thereby increasing the voltage supplied to collector 1110 of Q1101 to 50 volts.

The operation of the Figure 13 circuit is identical to that of Figure 11 up to this point. However, as the input signal voltage rises still further above 50 volts, transistor control 1130 operates to switch transistor Q1105 on, thus causing the potential appearing at emitter 1116 of Q1105 to be applied directly to the collector of transistor Q1101 through diode D1303. Due to the bias at 1156a at this time, the potential applied to the collector of Q1101 will be 67 1/2 volts. This will have the effect of back biasing diode D1301 to cause voltage from source E3 to be applied directly to transistor Q1101 through transistor Q1105.

Figure 14 is a graph representing the operation of the circuit of Figure 13, wherein line 1401 represents the output voltage on line 1158 of Figure 11 and line 1402 represents the voltage applied to the collector 1110 of transistor Q1101.

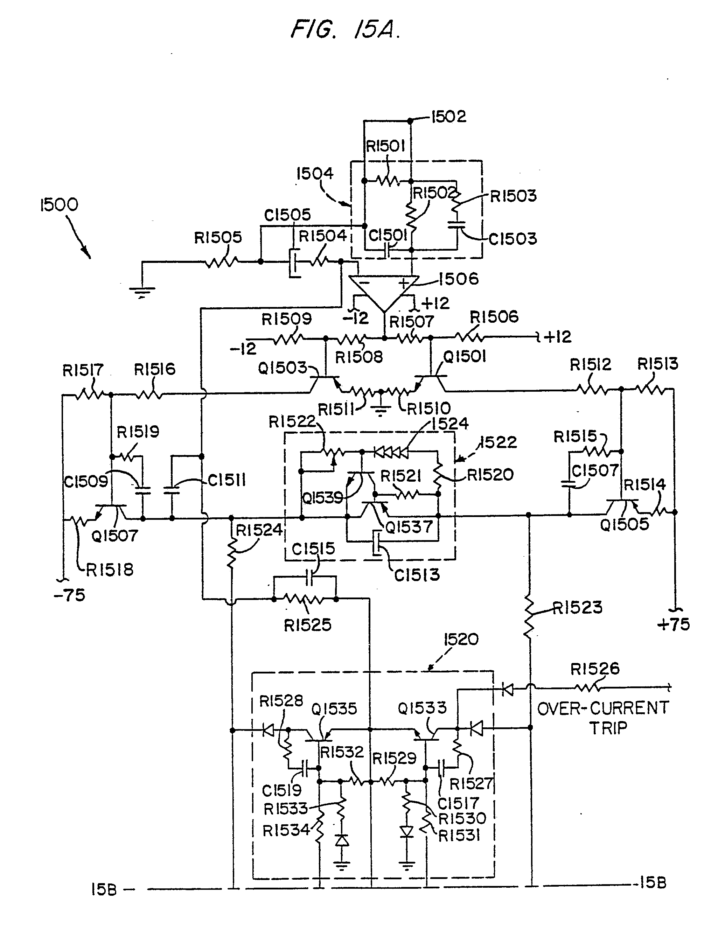

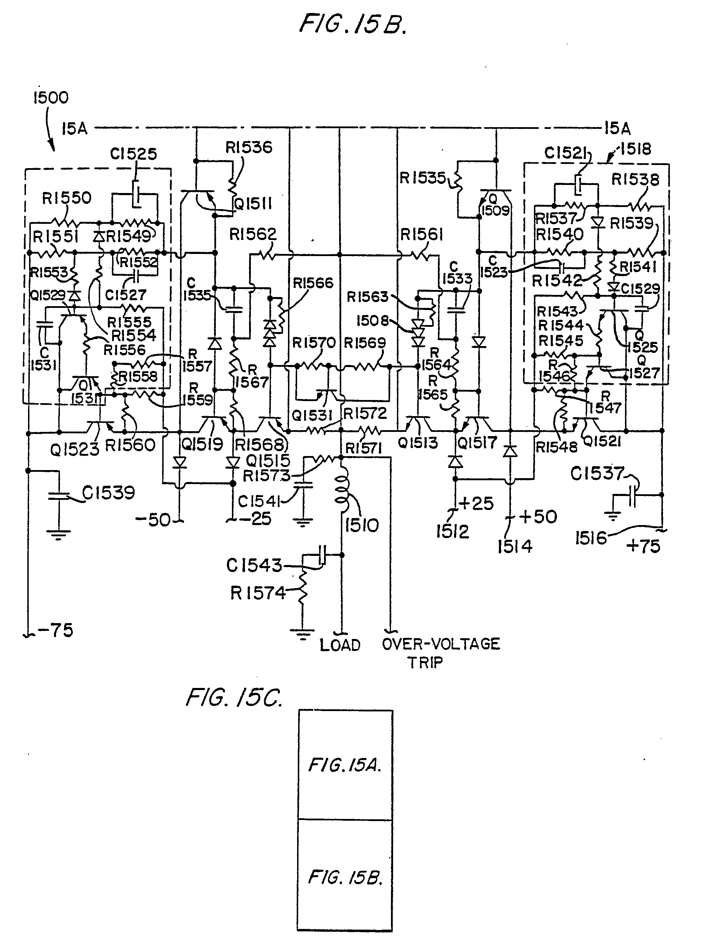

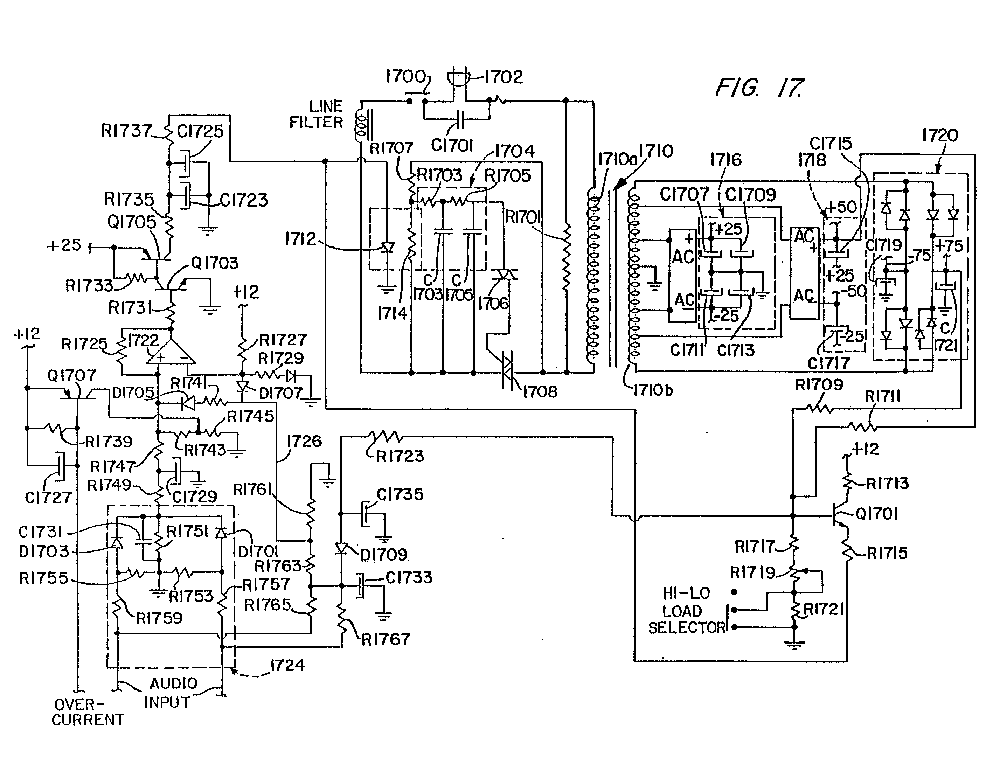

A preferred embodiment of the left and right channels of a stereo amplifier constructed un accordance with the present invention is illustrated in Figures 15A, 15B and 16. Referring first to the left channel circuitry 1500 illustrated in Figures 15A and 15B, a left channel input signal is received at terminal 1502 and preconditioned in a high frequency filter 1504 which rolls the audio signal off beyond 20 KHz. This filter acts to prevent transient intermodulation distortion. Upon leaving filter 1504, the input signal enters operational amplifier 1506 and thereafter passes to transistors Q1501 and Q1503, which split the input signal into positive and negative halves. The positive half of the signal is fed to the upper half of the left channel amplifier and the negative half of the signal is fed to the lower half of the left channel amplifier. Because the upper and lower halves of the left channel amplifier are symmetrical, only the upper half will be described in detail.

The output of transistor Q1501 is level shifted upwardly through the action of resistors R1512 and R1513 to the base of transistor Q1505. The signal appearing at the output collector of transistor Q1505 is transmitted to transistor Q1509. At very low output power requirements, the emitter current from transistor Q1509 flows through series arranged diodes, indicated at 1508, to the base of output transistor Q1513, whereupon transistor Q1513 begins conducting. Current from 25 volt power source 1512 then passes through output transistor Q1513 to an output inductor 1510 and on into the loudspeaker.

When output voltages above approximately 25 volts are required, the amplifier output current is derived from the 50 volt power source 1514 through output transistor Q1517. Similarly, when output voltages above 50 volts are required, transistor Q1509 drives output transistor Q1521 to derive current from the 75 volt power source 1516. Switching circuit 1518, including transistors Q1525 and Q1527, acts to apportion the voltage drop across the power transistors Q1513, Q1517 and Q1521.

The left channel amplifier includes an over-current protection circuit 1520. In the event of a short circuit across the output transistors, heavy currents are drawn through the amplifier, thereby creating a voltage drop across the emitter resistor R1571 of output transistor Q1513. This voltage drop in turn switches over-current protection transistor Q1533 on, and the current which normally flows through transistor Q1505 to the base of transistor Q1509 is instead diverted to flow through the collector of over-current protection transistor Q1533. Thus deprived of its drive current, transistor Q1509 will not turn on and the output transistors will not conduct. Consequently, the high power dissipations otherwise occurring under short circuit conditions are prevented.

Cross-over distortion is minimized by the action of transistors Q1537 and Q1539 in cross-over prevention circuit 1522. Transistors Q1537 and Q1539, together with the 1-2-3-4 series arranged diodes 1524, resistors R1520 and R1521, and capacitor C1513, form a bias network which develops a slight forward voltage drop between the bases of transistor Q1509 in the upper half of the left channel amplifier and transistor Q1511 in the lower half of the amplifier. This forward voltage drop places transistors Q1509 and Q1511 on the verge of conducting. When an audio signal is received by the amplifier, Q1509 and Q1511 will conduct immediately and without discontinuity in the amplifier output waveform, thereby resulting in very low distortion of the audio signal.

For purposes of convenience, the values of all the capacitors and resistors employed in the circuit of Figures 15A and 15B are listed in Table II below.

Figure 16 illustrates the input portion of the circuitry for the right channel amplifier. The right channel amplifier includes a network for shifting the phase of the incoming audio signal by 180° in order to better utilize the amplifier power supply. In all other respects, the right channel amplifier circuitry is identical to that of the left channel amplifier illustrated in Figures 15A and 15B.

Statistical analysis of stereo broadcasts indicates that the vast majority of audio signals associated with one channel of such broadcasts are in phase with the audio signals of the other channel. Prior art high fidelity amplifiers generally process incoming stereo signals without any modifications of the phase between the channels, operating in what is known as single ended fashion. The components of a stereo amplifier operating in single ended fashion, however, tend to drain additional energy from the power supply. When the amplifier output voltage is high, the positive side of the power supply furnishes power to both channels but the negative side of the power supply does no work. When the amplifier output voltage is low, the negative side of the power supply furnishes power to the amplifier but the positive side is not working.

Greater efficiency can be obtained from the amplifier if both sides of the power supply work continuously. In such situations, the power supply is said to be operated in bridge. Power can be delivered in the bridge mode to a two channel stereo amplifier by inverting the incoming signals in one of the amplifier channels and thereafter processing both channels in an out-of-phase fashion. As a result of the change in phase relationship between the otherwise generally in-phase stereo signals, positive power will always be required by one of the two amplifier channels while the remaining channel during any given power cycle will require negative power. Thus, regardless of the value of the amplifier output voltage, the positive and negative excursions of the power supply during each power cycle will both be employed. The greater power available at the amplifier output due to the fact thah the power supply is being utilized more efficiently can increase the output power by about 15—20%.

Again referring to Figure 16, the right channel amplifier is indicated generally at 1600. The audio input signal to the right channel is received at terminal 1601 and fed to inverting network 1602. The inverting network, which consists of capacitors C1601 and C1603 in combination with resistors R1601, R1603 and R1605, drives the inverting terminals of operational amplifier 1604. The values of the network components are listed in Table III below. Driving the inverting terminals of operational amplifier 1604 produces an output signal which is 180° out of phase with the input signal. As previously discussed, the majority of audio signals in each channel of a stereo broadcast are in phase. Consequently, the use of the inverting network generally results in a 180° phase difference between the operation of the left channel and the operation of the right channel of the amplifier.

Figure 17 is a preferred embodiment of the power source for the left and right channel amplifiers illustrated respectively in Figures 15A, 15B and 16. Referring now to Figure 17, when switch 1700 is closed, current begins to flow from A.C. power line 1702 through a phase shift network 1704 to Diac 1706 and Triac 1708. Triac 1708 turns on, permitting current flow through the primary 1710a of transformer 1710. The magnetic field in primary 1710a builds up, transferring energy to transformer secondary 1710b and then to electrolytic energy storage capacitor banks 1716, 1718 and 1720. Storage capacitor bank 1716 is designed to maintain a constant 25 volt output at the 25 volt power source, capacitor bank 1718 is designed to maintain a constant 50 volt output at the 50 volt power source, and capacitor bank 1720 is designed to maintain a constant 75 volt output at the 75 volt power source. The capacitors in the capacitor banks become fully charged within the first 100 milliseconds after the power supply is turned on.

When the voltages at the three power supplies respectively reach their preferred voltage levels of 25, 50 and 75 volts, control transistor Q1701 is forced into conduction and the emitter current from Q1701 flows through an LED diode 1712. In response to the emitter current, LED 1712 emits a red light which shines on photoresistor 1714 and lowers the photo-resistance value thereof. The lowering of the resistance value of photoresistor 1714 in turn acts to shunt some of the current flowing through phase shift network 1704, subsequently shifting the phase of the A.C. line signal and causing the Diac 1706 and Triac 1708 to fire at a later point on the incoming A.C. line sine wave.

Changes in the firing point of the Diac and Triac create variations in the conduction angles and corresponding variations in the amplifier output voltage. Such variations provide a means for tracking the audio signal whenever the audio signal frequency is below the repetition rate of the power supply line, e.g., below a frequency of 120 Hertz (2×60 Hertz). The incoming audio signal is summed at the junction of resistors R1765 and R1767, and is low passed by the time constant of the parallel combination of resistors R1765, R1767 and capacitor C1733. The resulting signal is then rectified by diode D1709 to form a D.C. voltage which is proportional to the output of the power amplifier. This proportional D.C. voltage is applied to capacitor C1735, from whence it is fed to control transistor Q1701. Control transistor Q1701 thereafter controls the operation of LED 1712 to vary the time constant of phase shift network 1704 as discussed above, generating greater amplifier output voltages under high signal conditions and lesser output voltages under lower signal conditions. The output of the power supply thus effectively tracks incoming audio signals having frequencies in the low audio range. This tracking ability makes it possible to further reduce the cost, size and weight of the amplifier unit.

Automatic shut down of the Figure 17 power supply as a result of over-current conditions is achieved through the use of operational amplifier 1722 and transistors Q1703 and Q1705. If a fault condition results in over-current delivery to the audio amplifier, an over-current trip signal from the circuit of Figure 15A is fed to the base of transistor Q1707. Transistor Q1707 switches on, causing the input port of operational amplifier 1722 to go high. The output of operational amplifier 1722 likewise goes high, switching transistors Q1703 and Q1705 on. The emitter of transistor Q1705 is connected to the 25 volt source and the collector of Q1705 is connected to capacitors C1723 and C1725. When transistor Q1705 turns on, the charge from the 25 volt supply is transferred to capacitors C1723 and C1725. Current then flows through LED 1712, causing the LED to shine brightly on photoresistor 1714. The resistance of photoresistor 1714 is accordingly lowered to a value sufficient to shunt virtually all of the current from the phase shift network 1704, thereby shutting the power supply down.

When the power supply is shut down, LED 1712 is maintained in a lighted condition by the charge stored in capacitors C1723 and C1725. After a shoft period of time (i.e., somewhere between 1/2 and 1 minute) the charge on capacitors C1723 and C1725 dissipates through the LED and LED begins to go dark again. The resistance of photoresistor 1714 consequently begins to rise and the power supply cuts back on. If the fault condition has been removed, the power supply remains on and the audio amplifier operates as before. If, however, the fault still exists, the over-current trip line activates transistor Q1707 and the power shut-off sequence is repeated.

An over-voltage trip network is indicated at 1724. The audio signal from the output of the audio amplifier drives the network, including resistors R1751, R1753, R1755, R1757 and R1759, capacitor C1731, and diodes D1701 and D1703, to form a D.C. signal which represents the time-average half-way rectified audio signal. Note that diodes D1701 and D1703 serve as OR gates as well as rectifiers. The output at the junction of resistors R1751 and R1753 (e.g., the time-average audio voltage) charges capacitor C1731. Capacitor C1731 is chosen such that a value representative of a pre-selected over-voltage value will cause capacitor C1731 to trip operational amplifier 1722, thereafter turning on transistors Q1703 and Q1705 to shut down the power supply in a manner analogous to that which occurs during over-current conditions.

If for any reason (i.e., amplifier failure or the dropping of a tone arm) a D.C. component should appear at the amplifier output, a D.C. voltage will appear at the junction of resistors R1761 and R1763. This voltage is carried through D.C. fault trip line 1726 to operational amplifier 1722, causing the operational amplifier to trip. When the D.C. component is positive, diode D1705 will conduct into the positive port of operational amplifier 1722 and the operational amplifier will go high. When the D.C. component is negative, diode D1707 will conduct into the negative or inverting port of operational amplifier 1722 and the output of the operational amplifier will also go high. In both cases, the power supply will be shut down following the switching of transistors Q1703 and Q1705 and the energization of LED 1712.

Tables listing the values of the various resistors and capacitors illustrated in Figures 15A, 15B, 16 and 17 follow. As previously discussed, Table II contains listings for the circuitry of Figures 15A and 15B. Table III includes the components of the inverting network of Figure 16, while Table IV discloses preferred values for the resistors and capacitors of Figure 17.

# 0 020 640

## TABLE II
Values of the resistors and capacitors used in the left channel
amplifier of Figures 15A and 15B

Resistors

| | | |
|---|---|---|
| R1501—15kΩ | R1526—39kΩ | R1551—22kΩ |
| R1502—2kΩ | R1527—100Ω | R1552—18kΩ |
| R1503—6.2kΩ | R1528—100Ω | R1553—4.7kΩ |
| R1504—390Ω | R1529—1kΩ | R1554—39Ω |
| R1505—2.7Ω | R1530—5.6kΩ | R1555—27kΩ |
| R1506—9.1kΩ | R1531—120Ω | R1556—4.7Ω |
| R1507—1.5kΩ | R1532—1kΩ | R1557—3.3kΩ |
| R1508—1.5kΩ | R1533—5.6kΩ | R1558—2.2kΩ |
| R1509—9.1kΩ | R1534—120Ω | R1559—3.3kΩ |
| R1510—1.5kΩ | R1535—1.5kΩ | R1560—33Ω |
| R1511—1.5kΩ | R1536—1.5kΩ | R1561—2.7kΩ |
| R1512—4.7kΩ | R1537—2.4kΩ | R1562—2.7kΩ |
| R1513—910Ω | R1538—22kΩ | R1563—10kΩ |
| R1514—47Ω | R1539—22kΩ | R1564—220Ω |
| R1515—1kΩ | R1540—18kΩ | R1565—220Ω |
| R1516—4.7kΩ | R1541—4.7kΩ | R1566—6.2Ω |
| R1517—910Ω | R1542—39Ω | R1567—220Ω |
| R1518—47Ω | R1543—27kΩ | R1568—220Ω |
| R1519—1kΩ | R1544—4.7kΩ | R1569—56Ω |
| R1520—12kΩ | R1545—3.3kΩ | R1570—62Ω |
| R1521—5.6kΩ | R1546—2.2kΩ | R1571—.1Ω |
| R1522—5kΩ | R1547—3.3kΩ | R1572—.1Ω |
| R1523—10Ω | R1548—33Ω | R1573—2.7Ω |
| R1524—10Ω | R1549—2.4kΩ | R1574—2.7Ω |
| R1525—12kΩ | R1550—22kΩ | |

23

TABLE II (contd.)

Capacitors

| | | |
|---|---|---|
| C1501—200 pF | C1517—.01 F | C1531—180 pF |
| C1503—.001 F | C1519—.01 F | C1533—.039 F |
| C1505—470 $\mu$F | C1521—22 $\mu$F | C1535—.039 F |
| C1507—100 pF | C1523—.0033 F | C1537—.1 F |
| C1509—100 pF | C1525—22 $\mu$F | C1539—.1 F |
| C1511—200 pF | C1527—.0033 F | C1541—.33 F |
| C1513—4.7 $\mu$F | C1529—180 pF | C1543—.33 F |
| C1515—10 pF | | |

TABLE III
Values of the resistors and capacitors used in the inverting network
of the right channel amplifier of Figure 16

| Resistors | Capacitors |
|---|---|
| R1601—3k$\Omega$ | C1601—200 pF |
| R1603—12k$\Omega$ | C1603—33 pF |
| R1605—15k$\Omega$ | |

TABLE IV
Values of the resistors and capacitors used
in the power supply of Figure 17

Resistors

| | | |
|---|---|---|
| R1701—1.2k$\Omega$ | R1725—9.1 M$\Omega$ | R1747—2 M$\Omega$ |
| R1703—150k$\Omega$ | R1727—510k$\Omega$ | R1749—1.6 M$\Omega$ |
| R1705—180k$\Omega$ | R1729—5.6k$\Omega$ | R1751—199k$\Omega$ |
| R1707—27k$\Omega$ | R1731—6.8k$\Omega$ | R1753—3.3k$\Omega$ |
| R1709—27k$\Omega$ | R1733—22k$\Omega$ | R1755—3.3k$\Omega$ |
| R1711—150k$\Omega$ | R1735—1$\Omega$ | R1757—4.7k$\Omega$ |
| R1713—1.5k$\Omega$ | R1737—3.6k$\Omega$ | R1759—4.7k$\Omega$ |
| R1715—390$\Omega$ | R1739—20k$\Omega$ | R1761—3.3k$\Omega$ |
| R1717—680$\Omega$ | R1741—100k$\Omega$ | R1763—6.8k$\Omega$ |
| R1719—200$\Omega$ | R1743—200k$\Omega$ | R1765—30k$\Omega$ |
| R1721—680$\Omega$ | R1745—20k$\Omega$ | R1767—60k$\Omega$ |
| R1723—10k$\Omega$ | | |

# 0 020 640

TABLE IV (contd.)

Capacitors

| | | |
|---|---|---|
| C1701—.1 F | C1713—2200 $\mu$F | C1725—2200 $\mu$F |
| C1703—.013 F | C1715—2200 $\mu$F | C1727—22 $\mu$F |
| C1705—.01 F | C1717—2200 $\mu$F | C1729—47 $\mu$F |
| C1707—2200 $\mu$F | C1719—3000 $\mu$F | C1731—.033 F |
| C1709—2200 $\mu$F | C1721—3000 $\mu$F | C1733—2.2 $\mu$F |
| C1711—2200 $\mu$F | C1723—2200 $\mu$F | C1735—2.2 $\mu$F |

Industrial Applicability

The above disclosed amplifier circuitry and methods are of particular economic importance in the field of audio amplifiers. The concepts disclosed herein permit dramatic reduction in the weight and cost of providing suitable power supplies and power transistors for high fidelity audio amplifiers and are particularly well adapted to stereophonic systems.

As an example of the dramatic weight reductions possible through implementation of the concepts of this invention, a completed commercial embodiment of a power supply and amplifier rated at 400 watts weighs only 4 kg. In contrast, the lightest prior art commercial amplifier of comparable power rating weighs approximately 16 kg.

**Claims**

1. An apparatus for amplifying an input signal having a variable amplitude, including amplifier means (2, 1100, 1500, 1600) for amplifying the amplitude variations of the input signal to produce an output signal corresponding to the input signal, said amplifier means (2, 1100, 1500, 1600) including an input signal receiving means (16, 1102, 1120, 1502, 1506, 1601, 1604) for receiving the input signal and a power receiving means (46, 48, E1, E2, E3, E4, E5, E6) for receiving electrical energy for producing the output signal and power supply means (4) for supplying power to said amplifier means, said power supply means including a source (6, 502, 702, 1702) of commercially available, sinusoidally varying supply voltage having a constant frequency, a transformer (10, 500, 700, 1000, 1710) having a primary winding and a secondary winding, said secondary winding being operatively connected to said power receiving means of said amplifier means, said primary winding being adapted to be connected to said source, power control means (12, 508, 708, 766, 1708) to cause variable amounts of electrical energy to be transmitted to the primary winding (8, 500A, 700A, 1000A, 1710A) of the transformer (10, 500, 700, 1000, 1710) to induce corresponding variable electrical energy in said secondary winding (22, 500B, 700B, 1000B, 1710B), said power con-

trol means (12, 508, 708, 766, 1708) including switch means (508, 708, GTOA, GTOB, 1708) connected between said source (6, 502, 702, 1702) and said primary winding (8, 500A, 700A, 1000A, 1710A) for operating in a conductive state in response to a control signal for a selected portion of each cycle of the sinusoidally varying supply voltage to cause said selected portion of the sinusoidally varying supply voltage to be applied across said primary winding (8, 500A, 700A, 1000A, 1710A) only when said switch means is in said conductive state, characterized by

(A) said input signal is an audio signal having a variable amplitude which varies at an audio frequency,

(B) control signal generating means (16, 18, 528, 1712) responsive to the time varying amplitude of said audio signal to generate said control signal for said power control means (12, 508, 766, 1708) to control the period of conduction of said switch means (508, 708, GTOA, GTOB, 1708) during each cycle of said sinusoidally varying supply voltage in correspondence with the time varying amplitude of said audio signal,

(C) said sinusoidally varying supply voltage of said source (6, 502, 702, 1702) has a constant frequency within the audio range,

(D) said input signal receiving means (16, 1102, 1120, 1502, 1506, 1601, 1604) is an audio signal receiving means (16, 1102, 1120, 1502, 1506, 1601, 1604) for receiving said audio signals, and

(E) said amplifier means (2, 1100, 1500, 1600) operates to amplify audio frequency amplitude variation in said audio signal,

whereby the time portion of each cycle of sinusoidally varying supply voltage during which idling currents pass through said primary winding (8, 500A, 700A, 1000A, 1710A) is minimized.

2. Apparatus as defined in claim 1, characterized in that said transformer (10, 500, 700, 1000, 1710) has a secondary to primary turn ratio of below 1.0, said primary winding (8, 500A, 700A, 1000A, 1710A) having induc-

25

tance above 30 millihenries and a coil wire gauge diameter above No. 18.

3. Apparatus as defined in claim 1, wherein said switch (Q113, 508, 708, GTOa, GTOb, 1708) means includes a solid state switch (Q113, GTOa, GTOb, 1708) connected between said source and said primary winding, said solid state switch (Q113, GTOa, GTOb, 1708) being responsive to said control signal to become conductive, said control signal generating means (16, 18, 118—130, 528, 1712) supplying variable control signals to said solid state switch (Q113, GTOa, GTOb, 1708) at variable times during each cycle of said sinusoidally varying supply voltage to cause said solid state switch (Q113, GTOa, GTOb, 1708) to begin conduction at varying times dependent upon the time varying amplitude of the audio signal.

4. Apparatus as defined in claim 2, wherein said power control means (GTOa, GTOb) further includes means (GTOb) responsive to a cut off control signal for cutting off flow of current to said primary winding (8, 104a, 500a, 700a, 1000a, 1710a), said control signal generating means including means for producing a cut off control signal in a manner to permit sufficient current to flow through said primary winding (8, 104a, 500a, 700a, 1000a, 1710a) to allow power of a magnitude which varies over time in relationship to the time varying characteristics of the audio signal while simultaneously minimizing the flow of idling currents through said primary winding (8, 104a, 500a, 700a, 1000a, 1710a).

5. Apparatus as defined in claim 2, wherein said control signal generating means (16, 18, 118—130, 528, 1712) includes a control link (26, 124, R505, R1709, R1711) for transmitting an electrical signal representative of the voltage level produced by said secondary winding (22, 104b, 500b, 700b, 1000b, 1710b) to said power control means (12, 116, 508, 708, 766, 1708) for causing the control signal to respond to variations in the output voltage produced by said power control means (12, 116, 508, 708, 766, 1703).

6. Apparatus as defined in claim 5, wherein said control link (26, 124, R505, R1709, R1711) includes an electro-optical link for preventing transfer of substantial electrical energy between said primary and second windings (8, 22, 104a, 104b, 500a, 500b, 700a, 700b, 1710a, 1710b) over said control link (1712, 1714).

7. Apparatus as defined in claim 3 further including fault condition sensing means (1520, R1747) for sensing faulty operation of said audio amplifier means (1600) to produce a fault signal, said control signal generating means (1712) including fault response means (1722) connected with said fault condition sensing means (1520, R1747) to cause said variable control signal to reduce the conductive duty cycle of said solid state switch (1708).

8. Apparatus as defined in claim 1, further including audio signal filter means (R1767, C1733, D1709, C1735, R1723) for generating an audio tracking signal representative of low frequency variations in the audio signal, said control signal generating means (1712) including audio signal responsive means (Q1701) to cause said power control means (1708) to modulate the power of pulses transferred to said primary winding (1710a) in response to low frequency variations in the amplitude of the audio signal.

9. Apparatus as defined in claim 1, wherein said audio amplifier means (2, 1100, 1500) includes first and second transistors (30, 34, Q1101, Q1103, Q1513, Q1517) having series connected emitter-collector circuits, said first transistor (30, Q1101, Q1513) having a base electrode arranged to receive the audio signal and an emitter arranged to produce at least a portion of the output signal of said audio amplifier means, and wherein said power supply means (6, 132, 502, 702, 1702, 24, 104, 500, 700, 1710) includes first voltage means ($V_2$, $E_1$, 1512) for providing a source of voltage at a first level to the connection between said first and second transistors (3, 34, Q1101, Q1103, Q1513, Q1517) and second voltage means ($V_1$, $E_2$, 1514) for providing a source of voltage at a second level higher than said first level to the emitter-collector circuit of said second transistor (34, Q1103, 1517); and transistor control means (38, 1126, Q1509, 1508) for holding said second transistor in a non-conductive state when the amplitude of said audio signal is below a first predetermined level and for causing said second transistor (34, Q1103, 1517) to conduct when the amplitude of said audio signal is above said first predetermined level.

10. Apparatus as defined in claim 9, wherein said transistor control means (38, 1126, Q1509, 1508) causes said first predetermined level to be equal to said first level and wherein said transistor control means (38, 1126, Q1509, 1508) further causes said first and second transistors (30, 34, Q1101, Q1103, Q1513, Q1517) to substantially equally bear the total voltage drop across said first and second transistors (38, 1126, Q1509, 1508) when the amplitude of said audio signal is above said predetermined level.

11. Apparatus as defined in claim 8, wherein said power supply means (6, 132, 502, 702, 1702, 24, 104, 500, 700, 1710) includes a third voltage means (E3, 1516) for providing a source of voltage at a third level higher than said second level and wherein said audio amplifier means (1100, 1500) includes a third transistor (Q1105, Q1521) having an emitter connected with said first and second transistors (Q1101, Q1103, Q1513, Q1517), and a collector connected with said third voltage means (E3, 1516) and further including second transistor control means (1130, 1518) connected with the base of said third transistor for holding said third transistor (Q1105, Q1521) in a non-conductive state when the amplitude of said audio signal is below a second predetermined level which is above said first predetermined level and for controlling the amplification of said third transistor (Q1105, Q1521) to cause said first and third transistors (Q1101, Q1513, Q1105, Q1521) to each bear a substantial portion of the total voltage drop across said first and third transistors (Q1101, Q1513, Q1105, Q1521) when the amplitude of said audio signal is above said second predetermined level.

12. Apparatus as defined in claim 11, wherein the emitter of said third transistor (Q1105, Fig. 13) is connected to the collector of said first transistor (Q1101, Fig. 13) and wherein said audio amplifier means (1100) includes a diode (D1301, Fig. 13) connected between said first and second transistors (Q1101, Q1103, Fig. 13) to isolate said second transistor (Q1103) from said first transistor (Q1101) when said third transistor (Q1105) is conductive.

13. Apparatus as defined in claim 10, wherein the emitter of said third transistor (Q1105, Q1521) is connected to the collector of said second transistor (Q1103, Q1517) and said first and second transistor control means (1126, 1130, 1508, Q1509, 1518) operates to cause said first, second and third transistors (Q1101, Q1103, Q1105, Q1513, Q1517, Q1521) to equally share the voltage drop thereacross when said third transistor (Q1105, Q1521) is conductive and wherein said audio amplifier means (1100, 1500) includes a pair of diodes (D1101, D1103) between the collectors of said first and second transistors (Q1101, Q1103) and said first and second voltage means (1512, 1514, $E_1$, $E_2$), respectively, said diodes (D1101, D1103) being arranged to isolate said first and second voltage sources (1512, 1514, $E_1$, $E_2$) when said third transistor (Q1105, Q1521) is conductive.

**Patentansprüche**

1. Vorrichtung zur Verstärkung eines Eingangssignales, welches eine variable Amplitude aufweist, mit wenigstens einer Verstärkereinrichtung (2, 1100, 1500, 1600) zur Verstärkung der Amplitudenvariationen des Eingangssignales um ein Ausgangssignal zu erzeugen, welches dem Eingangssignal entspricht, wobei die Verstärkereinrichtung (2, 1100, 1500, 1600) wenigstens eine Eingangssignalempfangseinrichtung (16, 1102, 1120, 1502, 1506, 1601, 1604) zum Empfang des Eingangssignales, wenigstens eine Leistungsempfangseinrichtung (46, 48, E1, E2, E3, E4, E5, E6) zur Aufnahme von elektrischer Energie um das Ausgangssignal zu erzeugen und eine Leistungszufuhreinrichtung (4) zur Zuführung von Leistung zu der Verstärkereinrichtung aufweist, wobei die Leistungszufuhreinrichtung eine Quelle (6, 502, 702, 1702) aus handelsüblicher, sich sinusförmig ändernder Spannung mit konstanter Frequenz, einen Transformator (10, 500, 700, 1000, 1710) mit einer Primärwindung und eine Sekund-ärwindung, wobei die Sekundärwindung mit der Leistungsempfangseinrichtung der Verstärkereinrichtung verbunden ist und die Primärwindung dafür ausgelegt ist, mit der Quelle verbunden zu werden, und eine Leistungssteuereinrichtung (12, 508, 708, 766, 1708) aufweist, um zu bewirken, daß sich ändernde Werte der elektrischen Energie, welche auf die Primärwindung (8, 500A, 700A, 1000A, 1710A) des Transformators (10, 500, 700, 1000, 1710) übertragen werden, in der Sekundärwindung (22, 500B, 700B, 1000B, 1710B) eine entsprechende variable elektrische Energie induzieren, wobei die Leistungssteuereinrichtung (508, GTOA, GTOB, 1708) eine Schalteinrichtung (508, 708, GTOA, GTOB, 1708) aufweist, welche zwischen der Quelle (6, 502, 702, 1702) und die Primärwindung (8, 500A, 700A, 1000A, 1710A) geschaltet ist, um als Antwort auf ein Steuersignal während eines ausgewählten Abschnittes eines jeden Zyklus der sich sinusförmig verändernden Zufuhrspannung in einen leitenden Zustand zu schalten, um zu bewirken, daß der ausgewählte Abschnitt der sich sinusförmig verändernden Zufuhrspannung nur dann an die Primärwindung (8, 500A, 700A, 1000A, 1710A) angelegt wird, wenn die Schalteinrichtung in dem leitenden Zustand ist, dadurch gekennzeichnet,

— daß (A) das Eingangssignal ein Audiosignal ist, welches eine variable Amplitude aufweist, welche sich innerhalb einer Audiofrequenz ändert;
— daß (B) eine Steuersignalerzeugungseinrichtung (16, 18, 528, 1712) vorgesehen ist, welche in Abhängigkeit von der Zeitveränderungssamplitude des Audiosignales ist, um das Steuersignal für die Leistungssteuereinrichtung (12, 508, 766, 1708) zu erzeugen, um die Zeitdauer des Leitens der Schalteinrichtung (508, 708, GTOA, GTOB, 1708) während jedes Zyklusses der sich sinusförmig verändernden Zufuhrspannung entsprechend der Zeitveränderungsamplitude des Audiosignales zu steuern;
— daß (C) die sich sinusförmig verändernde Zufuhrspannung des Quelle (6, 502, 702, 1702) eine konstante Frequenz innerhalb des Audiobereiches hat; .
— daß (D) die Eingangssignalempfangseinrichtung (16, 1102, 1120, 1502, 1506, 1601, 1604) eine Audiosignalempfangseinrichtung (16, 1102, 1120, 1502, 1506, 1601, 1604) zum Empfang des Audiosignales ist; und
— daß (E) die Verstärkereinrichtung (2, 1100, 1500, 1600) derart arbeitet, daß die Audiofrequenz-Amplitudenänderungen in dem Audiosignal verstärkt werden, wobei der Zeitabschnitt eines jeden Zyklus der sich sinusförmig verändernden Zufuhrspannung während dem Leerlaufströme durch die Primärwindung (8, 500A, 700A, 1000A, 1710A) laufen, minimiert wird.

2. Vorrichtung nach Anspruch 1, dadurch gekennzeichnet, daß der Transformator (10, 500, 700, 1000, 1710) ein Wicklungsverhältnis der zweiten zur ersten Windung von unter 1,0 hat, wobei die erste Windung (8, 500A, 700A, 1000A, 1710A) eine Induktivität von über 30 millihenry und einen Windungsdrahtdurchmesser über Nr. 18 hat.

3. Vorrichtung nach Anspruch 1, dadurch gekennzeichnet, daß die Schalteinrichtung (Q113, 508, 708, GTOa, GTOb, 1708) einen Halbleiterschalter (Q113, GTOa, GTOb, 1708) aufweist, welcher zwischen der Quelle und der Primärwindung geschaltet ist; daß der Halbleiterschalter (Q113, GTOa, GTOb, 1708) in Abhängigkeit von dem Steuersignal leitend wird; und daß die Steuersignalerzeugungseinrichtung (16, 18, 118, bis 130, 528, 1712) variable Steuersignale dem Halbleiterschalter (Q113, GTOa, GTOb, 1708) zu verschiedenen Zeiten während jedes Zyklus der sich sinusförmig verändernden Zufuhrspannung zuführt, um den Halbleiterschalter (Q113, GTOa, GTOb, 1708) zu veranlassen, zu verschiedenen Zeiten in Abhängigkeit von der Zeitveränderungsamplitude des Audiosignales mit der Leitfähigkeit zu beginnen.

4. Vorrichtung nach Anspruch 2, dadurch gekennzeichnet, daß die Leistungssteuereinrichtung (GTOa, GTOb) weiterhin eine Einrichtung (GTOb) aufweist, welche auf ein Abschaltsteuersignal reagiert, um·den Stromfluß zu der Primärwindung (8, 104a, 500a, 700a, 1000a, 1710a) zu unterbrechen; daß die Steuersignalerzeugungseinrichtung eine Einrichtung zur Erzeugung eines Abschaltsteuersignales derart aufweist, daß ein ausreichender Strom durch die Primärwindung (8, 104a, 500a, 700a, 1000a, 1710a) fließt, um eine Leistung mit einer Größe zu gestatten, welche sich über die Zeit im Vergleich zu den Zeitveränderungscharakteristika des Audiosignales ändert, wobei gleichzeitig der Fluß von Leerlaufströmen durch die Primärwindung (8, 104a, 500a, 700a, 1000a, 1710a) minimiert wird.

5. Vorrichtung nach Anspruch 2, dadurch gekennzeichnet, daß die Steuersignalerzeugungseinrichtung (16, 18, 118 bis 130, 528, 1712) ein Steuerglied (26, 124, R505, R1709, R1711) aufweist, um ein elektrisches Signal entsprechend der Spannungshöhe, welche von der Sekundärwindung (22, 104b, 500b, 700b, 1000b, 1710b) erzeugt wird auf die Leistungssteuereinrichtung (12, 116, 508, 708, 766, 1708) zu übertragen, um zu bewirken, daß das Steuersignal auf Änderungen in der Ausgangsspannung, welche von der Leistungssteuereinrichtung (12, 116, 508, 708, 766, 1703) erzeugt wird, zu antworten.

6. Vorrichtung nach Anspruch 5, dadurch gekennzeichnet, daß das Steuerglied (26, 124, R505, R1709, R1711) ein elektro-optisches Übertragungsglied aufweist, um zu verhindern, daß im wesentlichen elektrische Energie zwischen den Primär- und Sekundärwindungen (8, 22, 104a, 104b, 500a, 500b, 700a, 700b, 1710a, 1710b) über das Steuerglied (1712, 1714) übertragen wird.

7. Vorrichtung nach Anspruch 3, gekennzeichnet, durch eine Fehlerzustandserkennungseinrichtung (1520, R1747) zur Erkennung einer fehlerhaften Arbeitsweise der Audioverstärkereinrichtung (1600), um ein Fehlersignal zu erzeugen, wobei die Steuersignalerzeugungseinrichtung (1712) eine Fehlerantworteinrichtung (1722) aufweist, welche mit der Fehlerzustandserkennungseinrichtung (1520, R1747) verbunden ist, um zu bewirken, daß das variable Steuersignal die leitenden Zustandmomente des Halbleiterschalters (1708) verringert.

8. Vorrichtung nach Anspruch 1, gekennzeichnet durch Audiosignalfiltereinrichtungen (R1767, C1733, D1709, C1735, R1723) zur Erzeugung eines Audio-Spursignales entsprechend den Niederfrequenzveränderungen in dem Audiosignal, wobei die Steuersignaler-zeugungseinrichtung (1712). eine Audiosignal-Antworteinrichtung (Q1701) aufweist, um zu bewirken, daß die Leistungssteuereinrichtung (1708) die Leistung der Pulse, welche auf die Primärwindung (1710a) übertragen werden, als Antwort auf die Niederfrequenz-Veränderungen in der Amplitude des Audiosignales moduliert.

9. Vorrichtung nach Anspruch 1, dadurch gekennzeichnet, daß die Audioverstärkereinrichtung (2, 1100, 1500) erste und zweite Transistoren (30, 34, Q1101, Q1103, Q1513, Q1517) aufweist, welche in Serie geschaltete Emitter-Kollektorkreise aufweisen; daß der erste Transistor (30, Q1101, Q1513) eine Basiselektrode aufweist, welche das Audiosignal aufnimmt und einen Emitter aufweist, welcher wenigstens einen Teil des Ausgangssignales der Audioverstärkereinrichtung erzeugt; und daß die Leistungszufuhreinrichtung (6, 132, 502, 702, 1702, 24, 104, 500, 700, 1710) eine erste Spannungseinrichtung ($V_2$, $E_1$, 1512), um eine Spannungsquelle mit einem ersten Wert an der Verbindung zwischen dem ersten und zweiten Transistor (3, 34, Q1101, Q1103, Q1513, Q1517) zu schaffen und eine zweite Spannungseinrichtung ($V_1$, $E_2$, 1514) aufweist, um eine Spannungsquelle mit einem zweiten Wert, der höher ist als der erste Wert für den Emitter-Kollektorkreis des zweiten Transistors (34, Q1103, 1517) zu schaffen; und daß eine Transistorsteuereinrichtung (38, 1126, Q1509, 1508) vorgesehen ist, um den zweiten Transistor in einem nichtleitenden Zustand zu halten, wenn die Amplitude des Audiosignales unter einem ersten festgelegten Wert ist und um den zweiten Transistor (34, Q1103, 1517) durchzuschalten, wenn die Amplitude des Audiosignales über dem ersten festgelegten Wert ist.

10. Vorrichtung nach Anspruch 9, dadurch gekennzeichnet, daß die Transistorsteuereinrichtung (38, 1126, Q1509, 1508) den ersten festgelegten Wert gleich dem ersten Wert macht, wobei die Transistorsteuereinrichtung (38, 1126, Q1509, 1508) weiterhin bewirkt, daß der erste und zweite Transistor (30, 34, Q1101, Q1103, Q1513, Q1517) den gesamten Spannungsabfall über den ersten und zweiten Transistor (38, 1126, Q1509, 1508) im wesentlichen gleich tragen, wenn die Amplitude des Audiosignales über dem festgelegten Wert ist.

11. Vorrichtung nach Anspruch 8, dadurch gekennzeichnet, daß die Leistungszufuhreinrichtung (6, 132, 502, 702, 1702, 24, 104, 500, 700, 1710) eine dritte Spannungseinrichtung (E3, 1516) aufweist, um eine Spannungsquelle mit einem dritten Wert, der höher ist als der zweite Wert, zu schaffen, wobei die Audioverstärkereinrichtung (1100, 1500) einen dritten Transistor (Q1105, Q1521) aufweist, welcher einen Emitter aufweist, der mit dem ersten und zweiten Transistor (Q1101, Q1103, Q1513, Q1517) verbunden ist und einen Kollektor aufweist, welcher mit der dritten Spannungseinrichtung (E3, 1516) verbunden ist und weiterhin eine zweite Transistorsteuereinrichtung (1130, 1518) aufweist, die mit der Basis des dritten Transistors verbunden ist, um den dritten Transistor (Q1105, Q1521) in einem nichtleitenden Zustand zu halten, wenn die Amplitude des Audiosignales unter einem zweiten festgelegten Wert ist, der über dem ersten festgelegten Wert ist und um den Verstärkungsfaktor des dritten Transistors (Q1105, Q1521) zu steuern, um zu bewirken, daß der erste und dritte Transistor (Q1101, Q1513, Q1105, Q1521) jeweils einen wesentlichen Anteil des gesamten Spannungsabfalles über den ersten und dritten Transistor (Q1101, Q1513, Q1105, Q1521) tragen, wenn die Amplitude des Audiosignales über den zweiten festgelegten Wert ist.

12. Vorrichtung nach Anspruch 11, dadurch gekennzeichnet, daß der Emitter des dritten Transistors (Q1105, Fig. 13) mit dem Kollektor des ersten Transistors (Q1101, Fig. 13) verbunden ist, wobei die Audioverstärkereinrichtung (1100) eine Diode (D1301, Fig. 13) aufweist, welche zwischen dem ersten und zweiten Transistor (Q1101, Q1103, Fig. 13) geschaltet ist, um den zweiten Transistor (Q1103) von dem ersten Transistor (Q1101) zu isolieren, wenn der dritte Transistor (Q1105) leitet.

13. Vorrichtung nach Anspruch 10, dadurch gekennzeichnet, daß der Emitter des dritten Transistors (Q1105, Q1521) mit dem Kollektor des zweiten Transistors (Q1103, Q1517) verbunden ist und daß die ersten und zweiten Transistorsteuereinrichtungen (1126, 1130, 1508, Q1509, 1518) derart arbeiten, daß der erste, zweite und dritte Transistor (Q1101,

Q1103, Q1105, Q1513, Q1517, Q1521) den Spannungsabfall über sich gleich teilen, wenn der dritte Transistor (Q1105, Q1521) leitet, wobei die Audioverstärkereinrichtung (1100, 1500) ein Paar von Dioden (D1101, D1103) zwischen den Kollektoren des ersten und zweiten Transistors (Q1101, Q1103) bzw. zwischen der ersten und zweiten Spannungseinrichtung (1512, 1514, E$_1$, E$_2$) aufweist, wobei die Dioden (D1101, D1103) derart angeordnet sind, daß sie die erste und zweite Spannungsquelle (1512, 1514, E$_1$, E$_2$) isolieren, wenn der dritte Transistor (Q1105, Q1521) leitet.

## Revendications

1. Un dispositif destiné à amplifier un signal d'entrée ayant une amplitude variable, comprenant des moyens amplificateurs (2, 1100, 1500, 1600) prévus pour amplifier les variations d'amplitude du signal d'entrée afin de produire un signal de sortie correspondant au signal d'entrée, ces moyens amplificateurs (2, 1100, 1500, 1600) comprenant des moyens de réception de signal d'entrée (16, 1102, 1120, 1502, 1506, 1601, 1604) destinés à recevoir le signal d'entrée et des moyens de réception d'énergie (46, 48, E1, E2, E3, E4, E5, E6) destinés à recevoir de l'énergie électrique pour produire le signal de sortie et des moyens d'alimentation (4) destinés à fournir de l'énergie aux moyens amplificateurs, ces moyens d'alimentation comprenant une source (6, 502, 702, 1702) de tension d'alimentation à variation sinusoïdale, distribuée commercialement, ayant une fréquence constante, un transformateur (10, 500, 700, 1000, 1710) ayant un enroulement primaire et un enroulement secondaire, cet enroulement secondaire étant connecté fonctionnellement aux moyens de réception d'énergie des moyens amplificateurs, et l'enroulement primaire étant prévu pour être connecté à la source, des moyens de commande de puissance (12, 508, 708, 766, 178) destinés à faire en sorte que des quantités variables d'énergie électrique soient appliquées à l'enroulement primaire (8, 500A, 700A, 1000A, 1710A) du transformateur (10, 500, 700, 1000, 1710) pour induire de l'énergie électrique variable correspondante dans l'enroulement secondaire (22, 500B, 700B, 1000B, 1710B), ces moyens de commande de puissance (12, 508, 708, 766, 1708) comprendant des moyens de commutation (508, 708, GTOA, GTOB, 1708) connectés entre la source (6, 502, 702, 1702) et l'enroulement primaire (8, 500A, 700A, 1000A, 1710A), de façon à fonctionner dans un état conducteur sous l'effet d'un signal de commande, pendant une partie sélectionnée de chaque cycle de la tension d'alimentation à variation sinusoïdale, pour faire en sorte que cette partie sélectionnée de la tension d'alimentation à variation sinusoïdale ne soit appliquée aux bornes de l'enroulement primaire (8, 500A, 700A, 1000A, 1710A) que lorsque les moyens de commutation sont dans l'état conducteur, caractérisé en ce que:

(A) le signal d'entrée est un signal audio ayant une amplitude variable qui varie à une fréquence audio,

(B) des moyens de génération de signal de commande (16, 18, 528, 1712) réagissent à l'amplitude du signal audio, variant dans le temps, en générant le signal de commande pour les moyens de commande de puissance (12, 508, 766, 1708), afin de commander la période de conduction des moyens de commutation (508, 708, GTOA, GTOB, 1708) pendant chaque cycle de la tension d'alimentation à variation sinusoïdale, en correspondance avec l'amplitude variant dans le temps du signal audio,

(C) la tension d'alimentation à variation sinusoïdale de la source (6, 502, 702, 1702) a une fréquence constante comprise dans la gamme audio,

(D) les moyens de réception de signal d'entrée (16, 1102, 1120, 1502, 1506, 1601, 1604) sont des moyens de réception de signal audio (16, 1102, 1120, 1502, 1506, 1601, 1604) destinés à recevoir les signaux audio, et

(E) les moyens amplificateurs (2, 1100, 1500, 1600) amplifient la variation d'amplitude à fréquence audio dans le signal audio,

ce qui a pour effet de minimiser la partie de chaque cycle de la tension d'alimentation à variation sinusoïdale pendant laquelle des courants de repos circulent dans l'enroulement primaire (8, 500A, 700A, 1000A, 1710A).

2. Dispositif selon la revecdication 1, caractérisé en ce que le rapport entre le nombre de spires de l'enroulement secondaire et celui de l'enroulement primaire du transformateur (10, 500, 700, 1000, 1710) est inférieur à 1,0, l'enroulement primaire (8, 500A, 700A, 1000A, 1710A) ayant une inductance supérieure à 30 millihenrys et un diamètre de fil de bobinage inférieur à 1,02 mm.

3. Dispositif selon la revendication 1, dans lequel les moyens de commutation (Q113, 508, 708, GTOa; GTOb, 1708) comprennent un élément de commutation à l'état solide (Q113, GTOa, GTOb, 1708) connecté entre la source et l'enroulement primaire, cet élément de commutation à l'état solide (Q113, GTOa, GTOb, 1708) réagissant au signal de commande en devenant conducteur, les moyens de génération de signal de commande (16, 18; 118—130, 528, 1712) appliquant des signaux de commande variables à l'élément de commutation à l'état solide (Q113, GTOa, GTOb, 1708) à des instants variables pendant chaque cycle de la tension d'alimentation à variation sinusoïdale, pour que l'élément de commutation à l'état solide (Q113, GTOa, GTOb, 1708) commence à conduire à des instants variables en fonction de l'amplitude variant dans le temps du signal audio.

4. Dispositif selon la revendication 2, dans lequel les moyens de commande de puissance (GTOa, GTOb) comprennent en outre des moyens (GTOb) qui réagissent à un signal de commande de blocage en bloquant la circulation du courant vers l'enroulement primaire (8, 104a, 500a, 700a, 1000a, 1710a), les moyens de génération de signal de commande comprennant des moyens pour produire un signal de commande de blocage d'une manière qui permette la circulation d'un courant suffisant dans l'enroulement primaire (8, 104a, 500a, 700a, 1000a, 1710a), pour permettre l'obtention d'une puissance dont la valeur varie au cours du temps en relation avec les caractéristiques variables dans le temps du signal audio, en minimisant simultanément la circulation de courants de rapos dans l'enroulement primaire (8, 104a, 500a, 700a, 1000a, 1710a).

5. Dispositif selon la revendication 2, dans lequel les moyens de génération de signal de commande (16, 18, 118—130, 528, 1712) comprennent une liaison de commande (26, 124, R505, R1709, R1711) destinée à transmettre un signal électrique représentatif du niveau de tension produit par l'enroulement secondaire (22, 104b 500b, 700b, 1000b, 1710b) vers les moyens de commande de puissance (12, 116, 510, 708, 766, 1708), pour faire en sorte que la signal de commande réagisse à des variations de la tension de sortie produite par les moyens de commande de puissance (12, 116, 508, 708, 766, 1703).

6. Dispositif selon la revendication 5, dans lequel la liaison de commande (26, 124, R505, R1709, R1711) comprend une liaison électro-optique destinée à empêcher le transfert d'une quantité notable d'énergie électrique entre les enroulements primaire et secondaire (8, 22, 104a, 104b, 500a, 500b, 700a, 700b, 1710a, 1710b) par la liaison de commande (1712, 1714).

7. Dispositif selon la revendication 3, comprenant en outre des moyens de détection de condition de défaut (1520, R1747) destinés á détecter un fonctionnement défectueux des moyens amplificateurs audio (1600) de façon à produire un signal de défaut, les moyens de génération de signal de commande (1712) comprenant des moyens de réaction à un défaut (1722) connectés aus moyens de détection de condition de défaut (1520, R1747) pour faire en sortie que le signal de commande variable réduise le rapport cyclique de conduction de l'élément de commutation à l'état solide (1708).

8. Dispositif selon la revendication 1, comprenant en outre des moyens de filtrage de signal audio (R1767, C1733, D1709, C1735, R1723) destinés à produire un signal qui suit le signal audio et est représentatif de variations de basse fréquence dans le signal audio, les moyens de génération de signal de commande (1712) comprenant des moyens sensibles au signal audio (Q1701) destinés à agir sur les moyens de commande de puissance (1708) pour qu'ils modulent la puissance d'impulsions appliquées à l'enroulement primaire (1710a) sour l'effet de variations de basse fréquence dans l'amplitude du signal audio.

9. Dispositif selon la revendication 1, dans lequel les moyens amplificateurs audio (2, 1100, 1500) comprennent des premier et second transistors (30, 34, Q1101, Q1103, Q1513, Q1517) ayant des circuits émetteur-collecteur connectés en série, le premier transistor (30, Q1101, Q1513) ayant une électrode de base destinée à recevoir le signal audio et un émetteur destiné à produire au moins une partie du signal de sortie des moyens amplificateurs audio, et dans lequel les moyens d'alimentation (16, 132, 502, 702, 1702, 24, 104, 500, 700, 1710) comprennent des premiers moyens de génération de tension (V$_2$, E$_1$, 1512) destinés à appliquer une tension à un premier niveau à la connexion entre les premier et second transistors (3, 34, Q1101, Q1103, Q1513, Q1517) et des seconds moyens de génération de tension (V$_1$, E$_2$, 1514) destinés à appliquer une tension à un second niveau supérieur su premier niveau au circuit émetteur-collecteur du second transistor (34, Q1103, 1517); et des moyens de commande de transistors (38, 1126, Q1509, 1508) destinés à maintenir le second transistor dans un état bloqué lorsque l'amplitude du signal audio est inférieure à un premier nivea prédéterminé, et à provoquer la conduction du second transistor (34, Q1103, 1517) lorsque l'amplitude du signal audio est supérieure au premier niveau prédéterminé.

10. Dispositif selon la revendication 9, dans lequel les moyens de commande de transistors (38, 1126, Q1509, 1508) font en sorte que le premier niveau prédéterminé soit égal au premier niveau, et dans lequel les moyens de commande de transistors (38, 1126, Q1509, 1508) font en outre en sorte que les premier et second transistors (30, 34, Q1101, Q1103, Q1513, Q1517) supportent de façon pratiquement égale la chute de tension totale aux bornes des premier et second transistors (38, 1126, Q1509, 1508) lorsque l'amplitude du signal audio est supérieure au niveau prédéterminé.

11. Dispositif selon la revendication 8, dans lequel les moyens d'alimentation (6, 132, 502, 702, 1702, 24, 104, 500, 700, 1710) comprennent des troisièmes moyens de génération de tension (E3, 1516) destinés à fournir une tension à un troisième niveau supérieur au second niveau, et dans lequel les moyens d'amplification audio (1100, 1500) comprennent un troisième transistor (Q1105, Q1521) ayant un émetteur connecté aux premier et second transistors (Q1101, Q1103, Q1513, Q1517), et un collecteur connecté aux troisièmes moyens de génération de tension (E3, 1516), et comprenant en outre des seconds moyens de commande de transistors (1130, 1518) connectés à la base du troisième transistor pour maintenir ce troisième transistor (Q1105, Q1521) dans un état bloqué lorsque l'amplitude du signal audio est inférieure à un second niveau prédéterminé qui est supérieur au premier niveau prédéterminé, et pour commander l'amplification du troisième transistor (Q1105, Q1521) pour faire en sorte que chacun des premier et troisième transistors (Q1101, Q1513, Q1105, Q1521) supporte une partie notable de la chute de tension totale aux bornes des premier et troisième transistors (Q1101, Q1513, Q1105, Q1521) lorsque l'amplitude du signal audio est supérieure au second niveau prédéterminé.

12. Dispositif selon la revendication 11, dans lequel l'émetteur du troisième transistor (Q1105, Figure 13) est connecté au collecteur du premier transistor (Q1101, Figure 13) et dans lequel les moyens amplificateurs audio (1100) comprennent une diode (D1301, Figure 13) qui est connectée entre les premier et second transistors (Q1101, Q1103, Figure 13) pour isoler le second transistor (Q1103) par rapport au premier transistor (Q1101) lorsque le troisième transistor (Q1105) est conducteur.

13. Dispositif selon la revendication 10, dans lequel l'émetteur du troisième transistor (Q1105, Q1521) est connecté au collecteur du second transistor (Q1103, Q1517) et les premier et second moyens de commande de transistors (1126, 1130, 1508, Q1509, 1518) font en sorte que les premier, second et troisième transistors (Q1101, Q1103, Q1105, Q1513, Q1517, Q1521) se partagent de façon égale la chute de tension à leurs bornes lorsque le troisième transistor (Q1105, Q1521) est conducteur, et dans lequel les moyens amplificateurs audio (1100, 1500) comprennent une paire de diodes (D1101, D1103) branchées respectivement entre les collecteurs des premier et second transistors (Q1101, Q1103) et les premiers et seconds moyens de génération de tension (1512, 1514, E$_1$, E$_2$), ces diodes (D1101, D1103) étant branchées de façon à isoler les première et seconde sources de tension (1512, 1514, E$_1$, E$_2$) lorsque le troisième transistor (Q1105, Q1521) est conducteur.

FIG. 1.

0 020 640

FIG. 2.

FIG. 3.

3

FIG. 4.

FIG. 5.

FIG. 6A.

FIG. 6B.

FIG. 6C.

0 020 640

FIG. 7A.

E3 (+75 VOLTS)
750
E2 (+50 VOLTS)
748
E1 (+25 VOLTS)
746
752
E4 (-25 VOLTS)
754
E5 (-50 VOLTS)
756
E6 (-75 VOLTS)

0 020 640

FIG. 7B.

+75 VOLTS

CONTROL

702  708  760  762  700

758  764

700a

700b

FIG. 7C.

CONTROL

702  D703  GTOa

D701  GTOb

766

FIG. 8A.

800  802
802  800
800

FIG. 8B.

804  804
806  806
804

FIG. 8C.

808  808
810  810
808

FIG. 9A.

900  902  900  902
900  902

FIG. 9B.

904  906  904  906
904  906

FIG. 9C.

908  908  910
910
908  910

FIG. 10A.

FIG. 10B.

FIG. 10C.

FIG. 10D.

FIG. II.

# 0 020 640

**FIG. 12A.** VOLTAGE ACROSS Q1101

**FIG. 12B.** VOLTAGE ACROSS Q1103

**FIG. 12C.** VOLTAGE ACROSS Q1105

**FIG. 16.**

10

## FIG. 13.

E₃ (+75 VOLTS)

1130

1156a

Q1105

1116

1152a

D1303

E₂ (+50 VOLTS)

POWER SUPPLY VOLTAGE

+75

1124

Q1103

R1121

1156

Q1115

R1119

+75

1151

D1301

R1113    R1115

TO COLLECTOR 1110 OF Q1101

1126

E₁ (+25 VOLTS)

D1101

TO 1158

## FIG. 14.

75

67½

50    1402

37½

1401

25

TIME

11

*FIG. 15A.*

FIG. 15 B.

FIG. 15C.

FIG.15A.

FIG.15B.

FIG. 17.